# EUROPEAN PATENT APPLICATION

(11) **EP 4 746 293 A1**
(43) Date of publication of application: **20.05.2026**
(21) Application number: 25187055.6
(22) Date of filing: 02.07.2025
(51) Int. Cl.: H03K 3/012, H03K 3/3562

(54) **FLIP-FLOPS FOR A LOW POWER INTEGRATED CIRCUIT (IC)**

(30) Priority: 19.11.2024 IN 202441089760; 07.05.2025 KR 20250059258
(71) Applicant: Samsung Electronics Co., Ltd., Suwon-si, Gyeonggi-do 16677 (KR)
(72) Inventor: BANERJEE, Debojyoti, 560048 Bengaluru (IN); MANJUNATH, Nagashree, 560048 Bengaluru (IN); SHARMA, Priyamvada, 560048 Bengaluru (IN); DIMRI, Rakesh, 560048 Bengaluru (IN); AGARWAL, Somya, 560048 Bengaluru (IN)
(74) Representative: Marks & Clerk LLP

(57) **Abstract**

Embodiments relate to flip-flops for a low power integrated circuit (IC) in a standard cell library. A master stage flip-flop includes multistage cascaded inverters to generate a buffered data output for providing input to a slave stage flip-flop. A transistor bridge circuit is used for sharing a clock signal between the master stage flip-flop and the slave stage flip-flop. The slave stage flip-flop is configured to generate a final output using the generated buffered output from the master stage flip-flop.

## Description

### TECHNICAL FIELD

Embodiments disclosed herein relate to flip-flop circuits in semiconductor devices, and more particularly to flip-flops for a low power integrated circuit (IC) in a standard cell library.

### BACKGROUND

Flip-flops are vital components of a system on chip (SoC) integrated circuit (IC) and often are the determining factor of the SoC's area, power and performance. In low data toggle rates, the internal power consumed by the flip-flop often forms the major component of the total power of the chip.

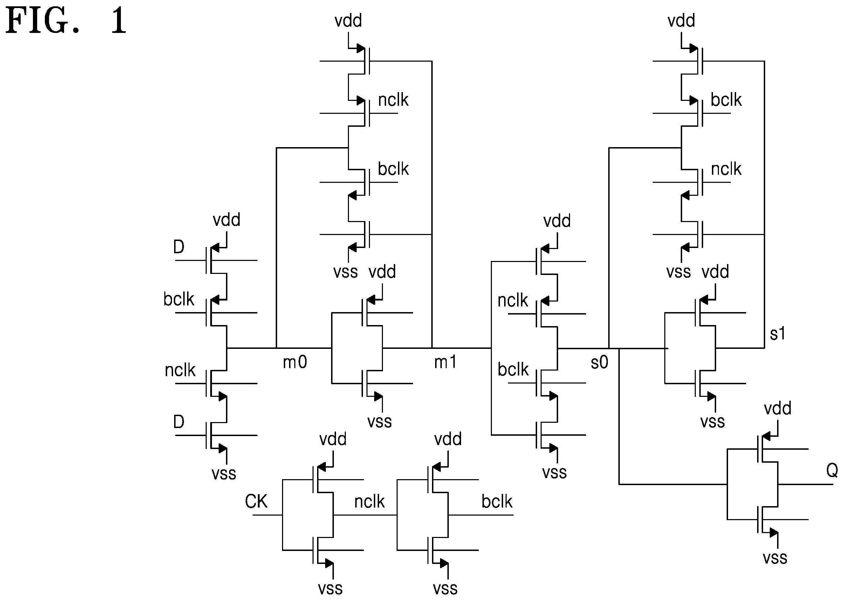

A conventional flip-flop has a transmission gate (SDFFQ) as shown in FIG. 1 with a clock (CK) buffer that operates continuously, resulting in burning significant amounts of power at low data toggle rates.

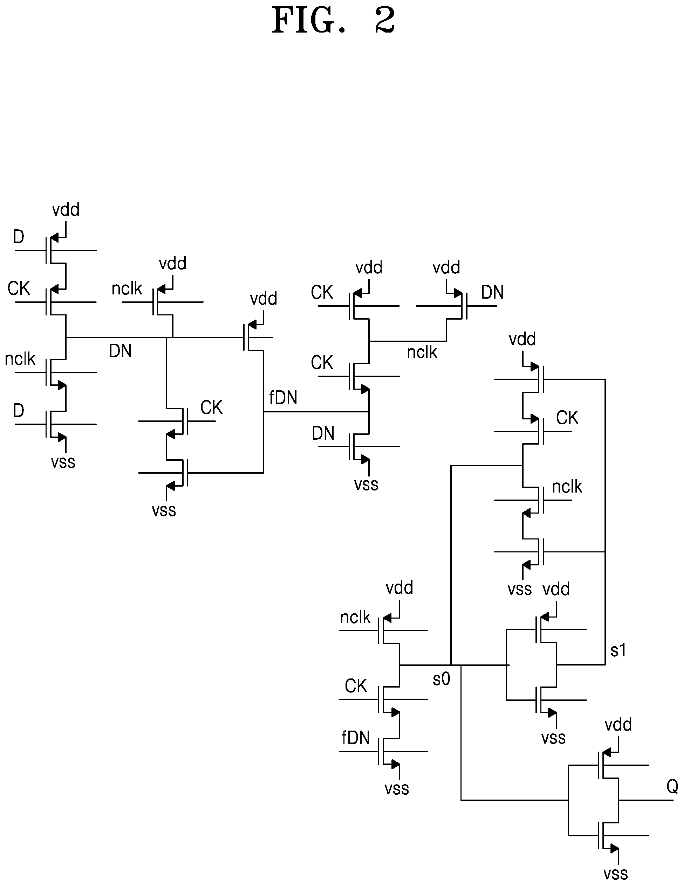

In a transmission gate (SDFFQCBM) (as shown in FIG. 2), one of the internal CKs is gated for one input condition; however, the gated CK is free running for other input arcs, making the flip-flops power comparable with SDFFQ. In SDFFQCBM the input CK pin is connected to multiple metal oxide semiconductor (MOS) devices, in turn loading the CK tree and increasing the CK tree power.

Therefore, there is a need for a fully gated, low power consuming flip-flop for a semiconductor integrated circuit.

### SUMMARY

An illustrative embodiment of the inventive concept relates to a flip-flop (e.g. for a low power integrated circuit (IC)), the flip-flop comprising a master stage flip-flop; a slave stage flip-flop; and a transistor bridge circuit for sharing a clock signal between the master stage flip-flop and the slave stage flip-flop. The master stage flip-flop is configured to generate a buffered data output on sensing a low phase of the clock signal from a received data input through a plurality of inverting stages comprising at least one controlled inverters coupled in series with a buffer, wherein a master stage internal feedback within the master stage flip-flop is provided by the buffered data output, the buffered inverted data and a high phase of the clock signal through a pull-down network. The slave stage flip-flop is configured to generate a final output using the generated buffered output from master stage flip-flop, wherein the generated buffered output controls the state of cross-coupled inverters connected to the active pull-down circuit in the slave stage flip-flop, and wherein a slave stage internal feedback within the slave stage flip-flop is provided by the buffered data output, buffered inverted data along with the low phase of the clock signal using the transistor bridge circuit in the pull up network.

Another illustrative embodiment relates to a reset flip-flop (e.g. for a low power integrated circuit (IC)), the reset flip-flop comprising a master stage flip-flop, a slave stage flip-flop; and a transistor bridge circuit for sharing a clock signal between the master stage flip-flop and the slave stage flip-flop. The master stage flip-flop is configured to provide an asynchronous reset input to the master stage flip-flop at its input port and the final output is reset to zero when the reset signal is turned high asynchronously. The master stage flip-flop is configured to generate a buffered data output upon sensing a low phase of the clock from a received data input through a plurality of inverting stages comprising at least one controlled inverter coupled in series with a buffer. The master stage internal feedback within the master stage flip-flop is provided by the buffered data output, the buffered inverted data and a high phase of the clock signal through a pull-down network. The slave stage flip-flop is configured to generate a final output using the generated buffered output from the master stage flip-flop and the state of the asynchronous reset signal. The output of the master stage flip-flop controls the state of the cross-coupled inverters connected to the active pull-down circuit in the slave stage flip-flop and further controls the final output. The slave stage internal feedback within the slave stage flip-flop is provided by the buffered data output, buffered inverted data along with the low phase of the clock signal using the transistor bridge in the pull up network.

Another illustrative embodiment relates to a flip-flop with scan functionality (e.g. for a low power integrated circuit (IC)), the flip-flop with scan functionality comprising a master stage flip-flop, a slave stage flip-flop; and a transistor bridge circuit for sharing clock signal between the master stage flip-flop and the slave stage flip-flop. The master stage flip-flop is further configured to generate a scan buffered output at a low phase of the clock based on a scan input and scan enable signals received at an input port of a multiplexer circuit at the input side of master stage flip-flop. The master stage internal feedback within the master stage flip-flop is provided by the scan buffered output, scan buffered inverted data and the clock signal when clock is high through a pull-down network. The slave stage flip-flop is configured to generate a final output using the generated scan buffered output from the master stage flip-flop. The generated scan buffered output controls the state of a cross-coupled inverters connected to the active pull-down in the slave stage flip-flop, and a slave stage internal feedback within the slave stage flip-flop is provided by the scan buffered data output, scan buffered inverted data along with the clock signal, when clock is low using the transistor bridge in the pull-up network.

An illustrative embodiment relates to a reset flip-flop with scan functionality (e.g. for a low power integrated circuit (IC)), the reset flip-flop with scan functionality comprising a master stage flip-flop, a slave stage flip-flop, and a transistor bridge circuit for sharing clock signal between the master stage flip-flop and the slave stage flip-flop. The master stage flip-flop is configured to provide an asynchronous reset input to the master stage flip-flop at its input port and, wherein the final output is reset to zero when reset signal is turned high asynchronously. The master stage flip-flop is further configured to generate a scan buffered output at a low phase of the clock based on the scan input and scan enable signals received at an input port of a multiplexer circuit at the input side of master stage flip-flop. A master stage internal feedback within the master stage flip-flop is provided by the scan buffered output, scan buffered inverted data and the clock signal when clock is high through a pull-down network. The slave stage flip-flop is configured to generate a final output using the generated scan buffered output from master stage flip-flop and the state of the asynchronous reset signal, wherein the output of the master stage flip-flop controls the state of the cross-coupled inverters connected to the active pull-down circuit in the slave stage flip-flop and further controls the final output. A slave stage internal feedback within the slave stage flip-flop is provided by the scan buffered data output, scan buffered inverted data along with the clock signal, when clock is low using the transistor bridge circuit in the pull-up network.

An illustrative embodiment relates to a multibit flip-flop with scan functionality (e.g. for a low-power integrated circuit (IC)) comprising a first stage one-bit flip-flop, and a second stage one-bit flip-flop. The first stage one-bit flip-flop and the second stage one-bit flip-flop are configured to use a scan input transfer function in a sequential manner. The first stage one-bit flip-flop is further configured to generate a scan output signal based on a scan input signal received at an input port of the first stage one-bit flip-flop. The second stage one-bit flip-flop is further configured to generate a scan final output signal based on the scan output signal received from the first stage at the scan input port of the second stage one-bit flip-flop.

At least some of the above and other features of the invention are set out in the

### BRIEF DESCRIPTION OF FIGURES

Embodiments herein are illustrated in the accompanying drawings, throughout which like reference letters indicate corresponding parts in the various figures. The embodiments herein will be better understood from the following description with reference to the following illustrated drawings. Embodiments herein are illustrated by way of examples in the accompanying drawings, and in which:
FIG. 1 shows a schematic of a flip flop (300) for a low power integrated circuit (IC) in a standard cell library, according to existing arts;
FIG. 2 shows a schematic of a flip flop for a low power integrated circuit (IC) in a standard cell library, according to existing arts;
FIG. 3A illustrates a block diagram of a flip flop for a low power integrated circuit (IC) in a standard cell library, according to embodiments as disclosed herein;
FIG. 3B illustrates a block diagram for master stage flip-flop (302) in a flip-flop circuit, according to embodiments as disclosed herein;
FIG. 3C illustrates a block diagram for slave stage flip-flop (304) in a flip-flop circuit, according to embodiments as disclosed herein;
FIG. 3D shows an example of a schematic of a flip flop (300) for a low power integrated circuit (IC) in a standard cell library, according to embodiments as disclosed herein;
FIG. 3E shows an example of the signal timing diagram of a flip-flop for a low power integrated circuit (IC) in a standard cell library, according to embodiments as disclosed herein;
FIG. 4A illustrates a block diagram of a reset flip-flop (400) for a low power integrated circuit (IC), according to embodiments as disclosed herein;
FIG. 4B illustrates a block diagram of the master stage flip-flop (402) for a reset flip-flop, according to embodiments as disclosed herein;
FIG. 4C illustrates a block diagram for slave stage flip-flop (404) in a reset flip-flop circuit, according to embodiments as disclosed herein;
FIG. 4D shows an example schematic of a reset flip flop (400) for a low power integrated circuit (IC) in a standard cell library, according to embodiments as disclosed herein;
FIG. 5A illustrates a block diagram of a master stage flip-flop (302), for a flip-flop with scan functionality for a low power integrated circuit (IC), according to embodiments as disclosed herein;
FIG. 5B illustrates a block diagram for a slave stage flip-flop (304) in a flip-flop circuit with scan functionality, according to embodiments as disclosed herein;
FIG. 5C shows an example of a schematic of a flip flop with scan functionality (500) for a low power integrated circuit (IC) in a standard cell library, according to embodiments as disclosed herein;
FIG. 6A illustrates a block diagram of a master stage flip-flop (402), for a reset flip-flop with scan functionality for a low power integrated circuit (IC), according to embodiments as disclosed herein;
FIG. 6B illustrates a block diagram for slave stage flip-flop (404) in a reset flip-flop circuit with scan functionality, according to embodiments as disclosed herein;
FIG. 6C shows an example schematic of a reset flip flop (400) with scan functionality (600) for a low power integrated circuit (IC) in a standard cell library, according to embodiments as disclosed herein;
FIG. 7A illustrates a block diagram of a multibit flip-flop with scan functionality (700) for a low power integrated circuit (IC) in a standard cell library, according to embodiments as disclosed herein;
FIG. 7B illustrates an example schematic of a multibit flip-flop with scan functionality (the first stage one-bit flip-flop) for a low power integrated circuit (IC) in a standard cell library, according to embodiments as disclosed herein; and
FIG. 7C illustrates an example schematic of a multibit flip-flop with scan functionality (the second stage one-bit flip-flop) for a low power integrated circuit (IC) in a standard cell library, according to embodiments as disclosed herein.

### DETAILED DESCRIPTION

Embodiments of the inventive concept described herein (hereafter, "embodiments") and the various features and advantageous details thereof are explained more fully with reference to the accompanying drawings and detailed in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

Various embodiments of the inventive concept (hereafter, "embodiment(s)") described below relate to flip-flops for a low power integrated circuit (IC) that may be designed as a building block of a standard cell library. Flip flop embodiments may have fully gated clock inputs, operate with a single phase of a clock (i.e., a true single phase design) and/or may have a lower transistor count than that of a standard flip-flop design.

An embodiment including a master stage flip-flop (i.e., a master stage of a flip-flop) may generate a buffered data output for providing input to a slave stage flip-flop (i.e., a slave stage of a flip-flop), where the master stage flip-flop includes multistage cascaded inverters. An embodiment including a transistor bridge circuit may share a clock signal between the master stage flip-flop and the slave stage flip-flop.

An embodiment may include master stage internal feedback within the master stage flip-flop, which is provided by the buffered data output and the buffered inverted data, during a high phase (high level) of the clock signal (or caused by a transition from a low phase to the high phase) through use of a pull-down network.

An embodiment may include a slave stage flip-flop configured for generating a final output using the generated buffered output from the master stage flip-flop.

An embodiment may include a slave stage internal feedback within the slave stage flip-flop provided by the buffered data output and buffered inverted data, during a low phase of the clock signal (or caused by a transition from the high to low phase) using the transistor bridge in the pull-up network.

An embodiment may include an input data-controlled inverter for providing an input to the master stage flip-flop.

An embodiment may include an input and scan multiplexer for receiving at least one of: (i) a data signal as an input to the master stage flip-flop on the input port based on a state of a scan enable pin of the flip-flop; or (ii) the scan input signal as the input based on the state of the scan enable pin of the flip-flop.

An embodiment may include an asynchronous reset signal as an input on the input port of the flip-flop.

Herein, the terms PMOS and NMOS may be used to refer, respectively, to a P-channel and an N-channel metal oxide semiconductor field effect transistor. Each PMOS and NMOS inherently includes a gate, a drain, and a source, which may be referred to herein as a gate, a drain, and a source, respectively.

Herein, when an element or signal is first introduced with a name followed by a label, the element or signal may be subsequently referred to by a shortened version of the name followed by the label, or by just the label itself. For example, a "PMOS P11" may be later referred to as just "P11".

For the purposes of interpreting this specification, the definitions (as defined herein) will apply and whenever appropriate the terms used in singular will also include the plural and vice versa. It is to be understood that the terminology used herein is for the purposes of describing particular embodiments only and is not intended to be limiting. The terms "comprising", "having" and "including" are to be construed as open-ended terms unless otherwise noted.

The words/phrases "exemplary", "example", "illustration", "in an instance", "and the like", "and so on", "etc.", "etcetera", "e.g.," , "i.e.," are merely used herein to mean "serving as an example, instance, or illustration." Any embodiment or implementation of the present subject matter described herein using the words/phrases "exemplary", "example", "illustration", "in an instance", "and the like", "and so on", "etc.", "etcetera", "e.g.," , "i.e.," is not necessarily to be construed as preferred or advantageous over other embodiments.

As used herein, such terms as "1st" and "2nd", or "first" and "second" may be used to simply distinguish a corresponding component from another, and do not limit the components in other aspect (e.g., importance or order). These numerical labels may be swapped or reordered without affecting the functionality of the device.

Embodiments herein may be described and illustrated in terms of blocks which carry out a described function or functions. These blocks, which may be referred to herein as managers, units, circuits, hardware components or the like, are physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks without departing from the scope of the disclosure. Likewise, the blocks of the embodiments may be physically combined into more complex blocks without departing from the scope of the disclosure.

It should be noted that elements in the drawings are illustrated for the purposes of this description and ease of understanding and may not have necessarily been drawn to scale. For example, the flowcharts/sequence diagrams illustrate the method in terms of the steps required for understanding of aspects of the embodiments as disclosed herein. Furthermore, in terms of the construction of the device, one or more components of the device may have been represented in the drawings by conventional symbols, and the drawings may show only those specific details that are pertinent to understanding the present embodiments so as not to obscure the drawings with details that will be readily apparent to those of ordinary skill in the art having the benefit of the description herein. Furthermore, in terms of the system, one or more components/circuits which comprise the system may have been represented in the drawings by conventional symbols, and the drawings may show only those specific details that are pertinent to understanding the present embodiments so as not to obscure the drawings with details that will be readily apparent to those of ordinary skill in the art having the benefit of the description herein.

Embodiments relate to flip-flops for a low power integrated circuit (IC), where the flip-flops may be designed in a standard cell library (e.g., logic circuits forming building blocks that can be combined together to form a chip).

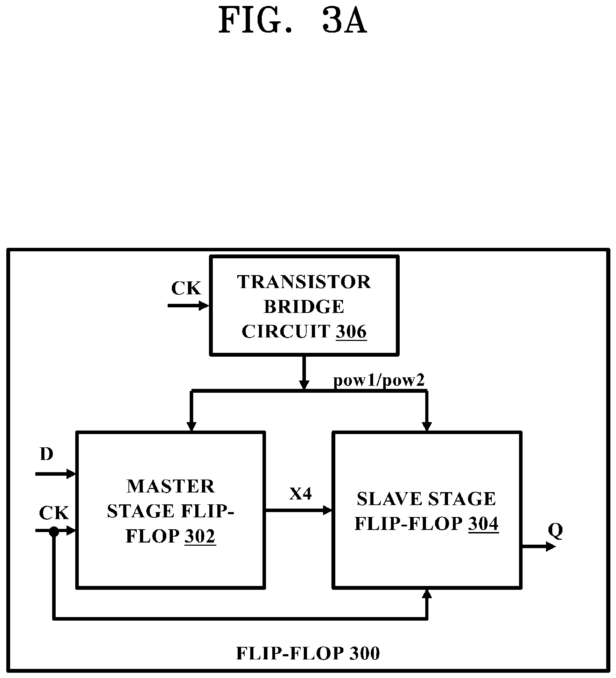

Referring now to the drawings, and more particularly to FIGS. 3A through 7C where similar reference characters denote corresponding features consistently throughout the figures, there are shown embodiments.

FIG. 3A illustrates a block diagram of a flip flop circuit ("flip flop") 300 for a low power integrated circuit (IC) in a standard cell library, according to embodiments. The flip-flop circuit 300 may comprise a master stage flip-flop 302, a slave stage flip-flop 304, and a transistor bridge circuit 306. The master stage flip-flop 302 may be otherwise known as a master stage (or a master stage of the flip flop). The slave stage flip-flop 304 may be otherwise known as known as a slave stage (or a slave stage of the flip flop). As alternatives to the terms "master" and "slave", the terms "primary" and "secondary", or "leader" and "follower" may be used. The transistor bridge circuit 306 takes clock signal CK as input and may provide signals (pow1/pow2) to the master stage flip-flop 302 and the slave stage flip-flop 304. In an embodiment, the flip-flop may be a D flip-flop. A D flip-flop may be a flip flop that stores a single bit of information (e.g. from a single data input, D). A D flip-flop may be configured to store a value of a data input, D, at a time point triggered by the clock signal CK.

The master stage flip-flop 302 may receive a data input D. An inverted data input may be received from a data controlled inverter which receives and inverts the input data input in the low phase (low voltage level) of the clock signal CK. The inverted data is received by a plurality of inverting stages comprising at least one controlled inverter coupled in series with a buffer. The master stage flip-flop 302 may generate a buffered data output X4 from the received data input. The master stage flip-flop 302 may generate the buffered data output X4 only on sensing a low phase of the clock signal CK.

The clock signal may alternate between a low voltage level (a logic low level) and a high voltage level (a logic high level). The term "low phase of the clock signal" may refer to a period of time during which the clock signal is at the low voltage level. The term "high phase of the clock signal" may refer to a period of time during which the clock signal is at the high voltage level. It will be appreciated that the terms "low" and "high" in this context are relative to each other - that is, that the low voltage level is a voltage level that is lower than the high voltage level. A threshold between the low voltage level and the high voltage level may be used to determine the current state (phase) of the clock signal.

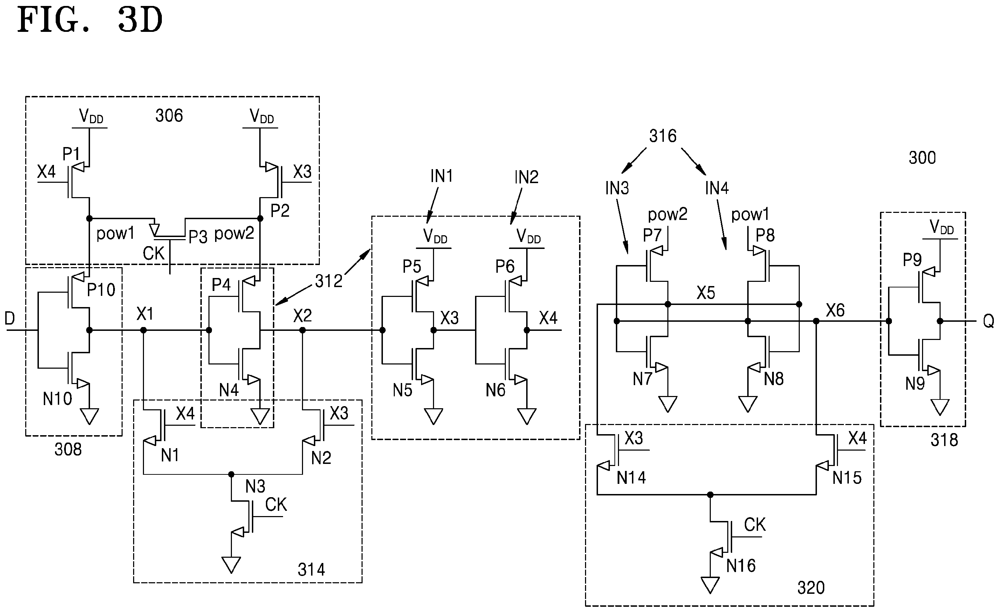

In an embodiment, the master stage flip-flop 302 may have a master stage internal feedback. The master stage internal feedback is provided through a pull-down network by the buffered data output X4 and the buffered inverted data (X3), which is the output of an inverter IN1 of FIG. 3D when the clock signal CK is active high. The master stage internal feedback may be provided when the clock signal CK is active high. The master stage internal feedback may be provided in the form of the previous master stage output generated during the low phase of the clock signal CK.

In an embodiment, the slave stage flip-flop 304 may generate a final output Q using the generated buffered output from the master stage flip-flop 302. The slave stage flip-flop 304 comprises cross-coupled inverters 316 connected to the active pull-down circuit 320 (e.g. through nodes X5 and X6). In an embodiment, the generated buffered output controls the state of the cross coupled inverters 316 in the slave stage flip-flop 304. During high phase of the clock signal CK, the active pull-down circuit 320 discharges one of the nodes X5 or X6 to zero based on the state of buffered data output X4 and buffered inverted data output X3 from the master stage flip-flop 302. A slave stage internal feedback within the slave stage flip-flop 304 is provided by the buffered data output X4, buffered inverted data X3 along with the low phase of the clock signal CK using the transistor bridge in the pull-up network.

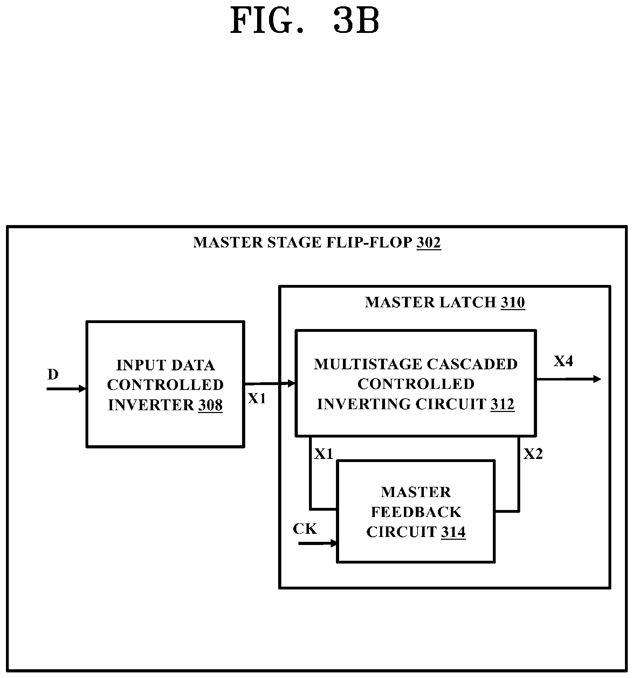

FIG. 3B illustrates a block diagram for master stage flip flop 302 in a flip-flop circuit, according to embodiments of the inventive concept. The master stage flip-flop 302 comprises an input data-controlled inverter 308 and a master latch 310. The master latch 310 comprises a multistage cascaded controlled inverting circuit 312 and a master feedback circuit 314.

In an embodiment, the input data-controlled inverter 308 receives an input D. When the clock signal CK from the transistor bridge circuit 306 is in low phase of the clock signal CK, the input data-controlled inverter 308 may generate the inverted input X1 data by receiving the input data D and inverting the input data D.

In an embodiment, the multistage cascaded controlled inverting circuit 312 receives the inverted data input X1 from the input data-controlled inverter 308, at a low phase of the clock signal CK. The multistage cascaded controlled inverting circuit 312 may generate the output of master stage in a form of buffered data output X4 from the received inverted data input X1. The buffered data output X4, as generated at the low phase of the clock signal CK, acts as the input to the slave stage flip-flop 304.

In an embodiment, the master feedback circuit 314 is active when clock signal CK is high. The master feedback circuit 314 provides the first internal feedback (master stage internal feedback) in the form of the previous master stage output generated during the low phase of the clock signal CK.

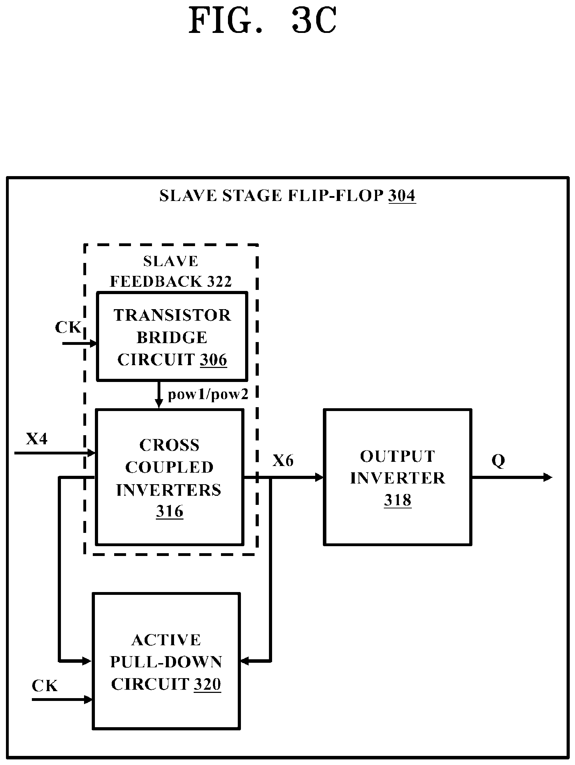

FIG. 3C illustrates a block diagram for slave stage flip flop 304 in a flip-flop circuit, according to embodiments. The slave stage flip-flop 304 comprises the cross-coupled inverters 316 (e.g. cross-coupled inverter circuit), which are coupled to the transistor bridge circuit 306 in the pull-up network. Herein, the cross-coupled inverters 316, which are coupled to the transistor bridge circuit 306 form the slave feedback circuit 322. The slave stage flip-flop 304 further comprises an output inverter 318 and an active pull-down circuit 320. The output of the cross-coupled inverters 316 are connected to the output inverter 318. The cross-coupled inverters 316 are coupled to the active pull-down circuit 320 in the pull-down network. The cross coupled inverters 316 receive the buffered data output X4 of the master stage flip-flop 302 as the input, at a high phase of the clock signal CK. The cross-coupled inverters 316 generate an output X6 using the received buffered data output X4 from the master stage flip-flop 302 during high phase of the clock signal CK using active pull-down circuit 320. At an active high phase of the clock signal CK, the output inverter 318 inverts the output X6 generated by the cross coupled inverters 316 to generate a final output Q.

In an embodiment, the output of the cross-coupled inverters 316 is controlled by the master stage flip-flop 302 based on the logic state of the buffered data output X4. The cross-coupled inverters 316 hold the state of the buffered data output X4 until the buffered data output X4 changes its state from the previous state. For example, if the cross-coupled inverters 316 hold the output X6 as 0 (X5 as 1) and the buffered data output X4 changes the state from 1 to 0, the cross coupled inverters 316 output X6 also changes the state from 0 to 1, as the clock signal CK transitions from low to high using the active-pull-down circuit 320 which discharges the X5 node to 0 and eventually inverts the X6 node through inverter IN4.

In an embodiment, the slave feedback circuit 322 provides the second internal feedback (e.g. slave stage internal feedback), through the transistor bridge circuit 306 at a low phase of the clock signal CK. The second internal feedback comprises a previous slave stage output during the high phase of the clock signal CK.

FIG. 3D shows an example schematic of a flip-flop 300 for a low power integrated circuit (IC) in a standard cell library, according to embodiments. Here, the transistor bridge circuit 306 includes three PMOSs: PMOS P1, PMOS P2 and PMOS P3. The sources of P1 and P2 are connected to a supply voltage VDD (i.e., "connected to receive VDD" via connection to a node / terminal that supplies VDD). The PMOS P3 is connected as a bridge between the drains of the PMOS P1 and the PMOS P2. The PMOS P3 receives a clock input at its gate to trigger (e.g., turn on at a clock edge transition) the PMOS P3.

In an embodiment, the input data-controlled inverter 308 includes a pull-up transistor embodied as a PMOS P10, which has its source connected to the drain of PMOS P1. The input data-controlled inverter 308 further includes a pull-down transistor exemplified as an NMOS N10, whose source is grounded. The gates of P10 and N10 are connected in common to receive the input D to the master stage flip-flop 302. The gates of P10 and N10 receive the input D when the clock signal CK from the transistor bridge 306 is in active low phase. The drains of the pull-up and pull-down transistors P10 and N10 are also connected together at a common output node, to provide inverted data as a first output X1 of the input data-controlled inverter 308 using the received input data D as a first common input at the gates of the pull-up and the pull-down transistors.

In an embodiment, the multistage cascaded controlled inverting circuit 312 includes a clock-controlled inverter that may include a PMOS P4 and an NMOS N4. The source of P4 is connected to the drain of P2. The source of N4 is grounded. The gates of P4 and N4 are connected in common to the output X1 of the input data-controlled inverter 308. The multistage cascaded controlled inverting circuit 312 receives inputs from the input data-controlled inverter 308. The drains of P4 and N4 are connected in common and provide inverted data as the output X2 of the clock-controlled inverter during low phase of the clock signal CK.

In an embodiment, the multistage cascaded controlled inverting circuit 312 includes inverters IN1 and IN2 cascaded in series. Inverters IN1 and IN2 are also known as buffer inverters. (Hereafter, the multistage cascaded inverter may be interchangeably referred to as (IN1+IN2).) The inverters IN1 and IN2 may form a buffer.

In an embodiment, the inverter IN1 includes a PMOS P5 and an NMOS N5. The source of the PMOS P5 is connected to the source supply voltage VDD, and the source of the NMOS N5 is grounded. The gates of the PMOS P5 and the NMOS N5 are connected in common to the output X2 of the clock-controlled inverter. The drains of the PMOS P5 and the NMOS N5 are connected in common and provide inverted data as the output X3 of the inverter IN1.

In an embodiment, the inverter IN2 includes a PMOS P6 and an NMOS N6. The source of P6 is connected to receive the source supply voltage VDD and the source of N6 is grounded. The gates of P6 and N6 are connected in common to the output X3 of the inverter IN1. The drains of P6 and N6 are connected in common and provide inverted data as the output X4 of the inverter IN2. The inverter IN2 provides the output X4 when the clock signal CK is at the low phase. The output X4 is the final buffered data output of the master stage flip-flop 302.

In an embodiment, the output of the inverter IN1 and inverter IN2 are given as inputs to the gates of the PMOS P1 and the PMOS P2 of the transistor bridge circuit 306. The PMOS P1 and the PMOS P2 receive X4 and X3 as an input at the gates of PMOS P1 and the PMOS P2 respectively. X3 and X4 are the outputs generated from the last two inverters IN1 and IN2 of the multistage cascaded controlled inverting circuit 312. Any of the one outputs X3, X4 may always be active high, therefore, at least one of the PMOS P1 and the PMOS P2 is in an active state irrespective of the clock signal CK.

In an embodiment, a master feedback circuit 314 includes two pull-down paths. The first pull-down path includes an NMOS N1 connected in series with an NMOS N3. The second pull-down path includes an NMOS N2 connected in series with the NMOS N3. The sources of the NMOS N1 and the NMOS N2 are connected in common in series with the drain of NMOS N3. The gate of the NMOS N3 is connected to the clock signal CK. The drain of the NMOS N1 is connected to the output X1 of the input data-controlled inverter 308. The drain of the NMOS N2 is connected to the output X2 of the clock-controlled inverter of the multistage cascaded inverting circuit 312. The gates of NMOS N1 and NMOS N2 are connected to the inverting signals X4 and X3, respectively. The gate of the NMOS N1 is connected to the buffered data output X4 generated by the buffer inverter IN2. The gate of the NMOS N2 is connected to the inverting output X3 of the buffer inverter IN1. As one of the buffered outputs X3, X4 is always one, at least one of the NMOS N1 and NMOS N2 is ON irrespective of the phase of the clock signal CK. When the clock signal CK is high, the master stage feedback circuit 314 provides the output of the previous state as the feedback which is generated during the previous low phase of the clock signal CK.

In an embodiment, the cross-coupled inverters 316 include two inverters IN3, IN4 connected back to back. The drains of a PMOS P7 and an NMOS N7 of IN3 are connected in common to the gates of a PMOS P8 and an NMOS N8 of the inverter IN4. The drains of the PMOS P8 and the NMOS N8 of IN4 are connected in common to the gates of the PMOS P7 and the NMOS N7 of the inverter IN3. The gates of the inverters IN3 and IN4 are driven by two pull-down paths of the active pull-down circuit 320. The first pull-down path comprises an NMOS transistor N14 connected in series with another NMOS N16. The second pull-down path comprises an NMOS N15 in series with the NMOS N16. The sources of the NMOS N14 and the NMOS N15 are connected in common, in series with a drain of the NMOS N16. The source of the NMOS N16 is grounded. The gate of the NMOS N16 is connected to receive the clock signal CK. The gate of the NMOS N14 is connected to the inverted output X3 from IN1 of the multistage cascaded controlled inverting circuit 312. The gate of the NMOS N15 is connected to the buffered output X4 from IN2 of the multistage cascaded controlled inverting circuit 312.

In an embodiment, the drain of the NMOS N14 is connected to the drains of the inverter IN3 and the gates of IN4. The drain of the NMOS N15 is connected to the drains of the inverter IN4 and the gates of inverter IN3.

In an embodiment, the cross-coupled inverters 316 generate the final output Q through the output inverter 318 (formed by a PMOS P9 and an NMOS N9 connected in the same manner as P10 and N10) using the received buffered data output from the master stage flip-flop 302 (including circuits 308, 312 and 314) during the high phase (high voltage level) of the clock signal CK. The master stage flip-flop 302 controls the output of the cross-coupled inverters 316 connected to active pull-down circuit 320 based on the logic state of the received master stage output.

In an embodiment, at a low phase of the clock signal CK, the buffer output of the master stage flip-flop 302 follows the input to the input data-controlled inverter 308. Where a first signal is described as "following" a second signal, this may represent that the first signal is a delayed (e.g. buffered) version of the second signal. When the clock signal CK is detected as high, the master feedback circuit becomes activated to hold the last buffer state at the low phase of the clock signal CK.

In an embodiment, the slave stage flip-flop 304 conducts (e.g. conducts or outputs a signal) on receiving a positive edge of the clock signal CK. Based on the master stage flip-flop 302 output X4, the slave stage flip-flop 304 controls the state of final output Q. In an embodiment, the cross-coupled inverter (IN3+IN4) coupled with transistor bridge circuit 306 in the pull-up network holds a previous final output (Q') when the clock signal CK is zero, and the previous final output (Q') acts as the feedback to the slave stage flip-flop 304.

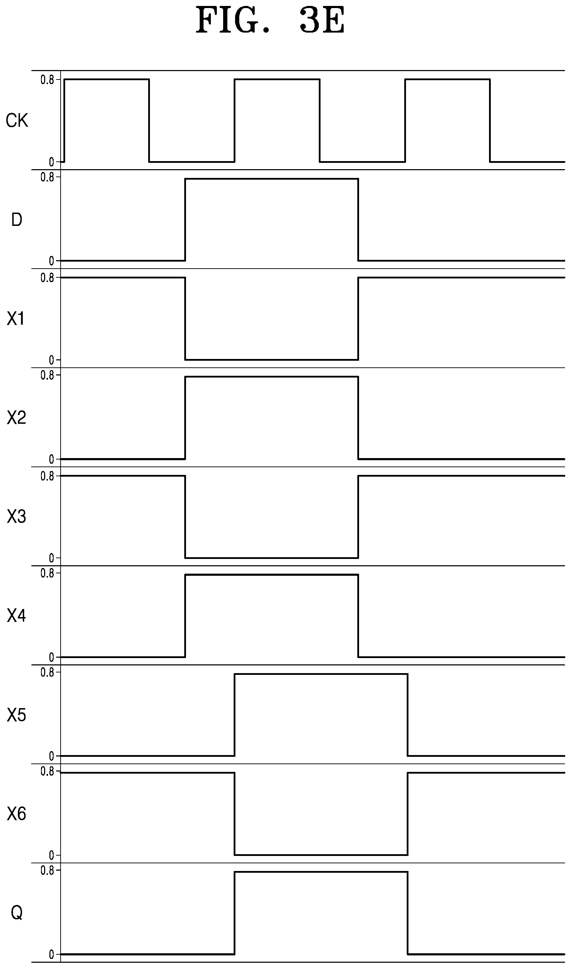

FIG. 3E shows an example of the signal timing diagram of a flip-flop for a low power integrated circuit (IC) in a standard cell library, according to embodiments as disclosed herein. The FIG 3E shows various input and internal signals along with the output signal. As described in FIG. 3B and FIG. 3C, at a low phase of the clock signal CK, an input D as active high (i.e. 1) is provided to the input inverter that generates output X1 as 0.

In an embodiment, at the low phase of the clock signal CK the multistage cascaded controlled inverting circuit 312 receives the inverted data input X1 as 0 from the input data-controlled inverter 308. The multistage cascaded controlled inverting circuit 312 generates the output of the master stage in the form of buffered data output X4 as 1 from the received inverted data input X1 = 0. The buffered data output X4 = 1 acts as the input to the slave stage flip-flop 304.

As shown in FIG. 3E as the clock signal CK goes high, the output X4 of the master stage flipflop 302 is received as input X5 to the slave stage flipflop 304. When the buffered data output X4 changes the state from 1 to 0, the cross coupled inverters 316 output X6 changes the state from 0 to 1 as the clock signal transitions from low to high using the active-pull-down circuit which discharges the X5 node to 0 and eventually inverts the X6 node through inverter IN4. As the X6 become 0, the final output Q is generated as 1, at a high phase of the clock signal CK.

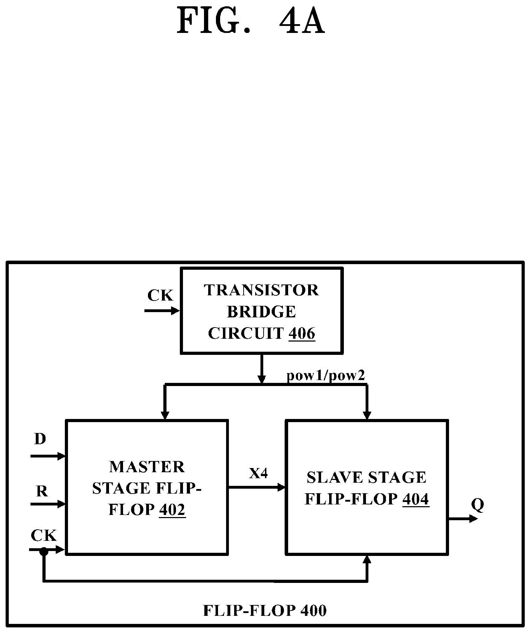

FIG. 4A illustrates a block diagram of a reset flip-flop 400 for a low power integrated circuit (IC), according to embodiments. The reset flip-flop 400 includes a master stage flip-flop 402, a slave stage flip-flop 404, and a transistor bridge circuit 406. The transistor bridge circuit 406 can be used for sharing the clock signal CK between the master stage flip-flop 402 and the slave stage flip-flop 404.

The master flip-flop 402 receives an asynchronous reset signal R as input to the master stage flip-flop 402 at the input port. The master flip-flop 402 resets the final output to zero, when the reset signal R is turned high asynchronously.

In an embodiment, the master stage flip-flop 402 may have a master stage internal feedback. The master stage internal feedback is provided through a pull-down network by the buffered data output X4 and the buffered inverted data X3, at a high phase of the clock signal CK. The master stage internal feedback may be provided in the form of the previous master stage output generated during the low phase of the clock signal CK.

In an embodiment, the slave stage flip-flop 404 may generate a final output Q using the generated buffered output from the master stage flip-flop 402. The slave stage flip-flop 404 comprises cross-coupled NOR-inverter circuit 416 connected to the active pull-down circuit 420 in pull-down network. In an embodiment, the generated buffered output controls the state of the cross coupled NOR-inverter circuit 416 and active pull-down circuit 420 in the slave stage flip-flop 404. During high phase of the clock signal CK, the active pull-down circuit 420 discharges one of the nodes X5 or X6 to zero based on the state of buffered data output X4 and buffered inverted data output X3 from the master stage flip-flop 402. A slave stage internal feedback within the slave stage flip-flop 404 is provided by the buffered data output X4, buffered inverted data X3 along with the low phase of the clock signal CK using the transistor bridge circuit 406 in the pull-up network.

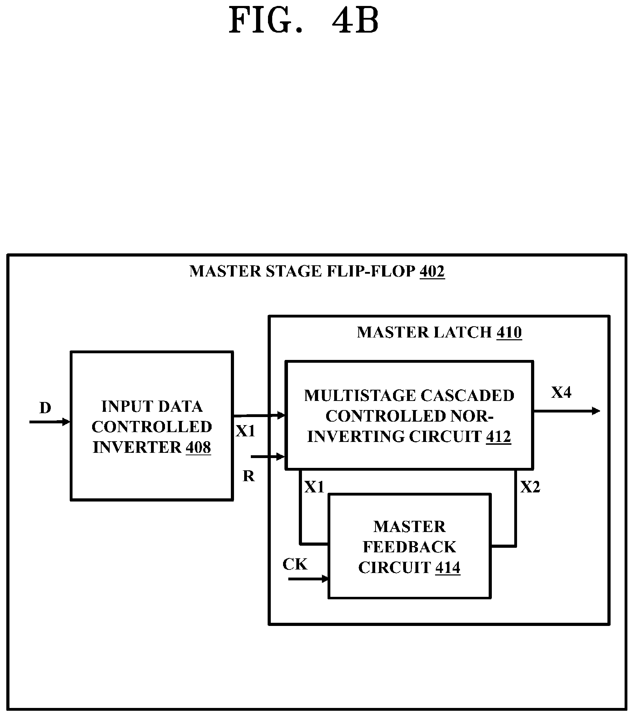

FIG. 4B illustrates a block diagram of the master stage flip-flop 402 for a reset flip-flop, according to embodiments. The master stage flip-flop 402 comprises an input data-controlled inverter 408 and a master latch 410. The master latch 410 comprises a multistage cascaded controlled NOR-inverting circuit with reset functionality 412 followed by a buffer, and a master feedback circuit 414.

The master flip-flop 402 receives an asynchronous reset signal R as input to the master stage flip-flop 402 at the input port. When the reset signal R is turned high asynchronously, the master flip-flop 402 resets the final output Q to zero.

In an embodiment, the input data-controlled inverter 408 receives an input data D. When the clock signal CK from the transistor bridge circuit 406 is in low phase of the clock signal CK, the input data-controlled inverter 408 may generate the inverted input data by receiving the input data D and inverting the input data D.

In an embodiment, the multistage cascaded controlled NOR-inverting circuit 412 with reset functionality receives the inverted data input X1 from the input data-controlled inverter 408 through a NOR gate, at a low phase of the clock signal CK. The multistage cascaded controlled NOR-inverting circuit 412 may generate the output of the master stage in a form of buffered data output X4 from the received inverted data input. The NOR gate is enabled with a reset signal R coupled in series with a buffer to reset the master stage output from a received high asynchronous reset signal R provided at the input port of the flip-flop by resetting the output of controlled NOR circuit to zero (X2 as well as X4).

In an embodiment, the master feedback circuit 414 is active when the clock signal CK is high. The master feedback circuit 414 provides the first internal feedback in the form of the previous master stage output generated during the low phase of the clock signal CK.

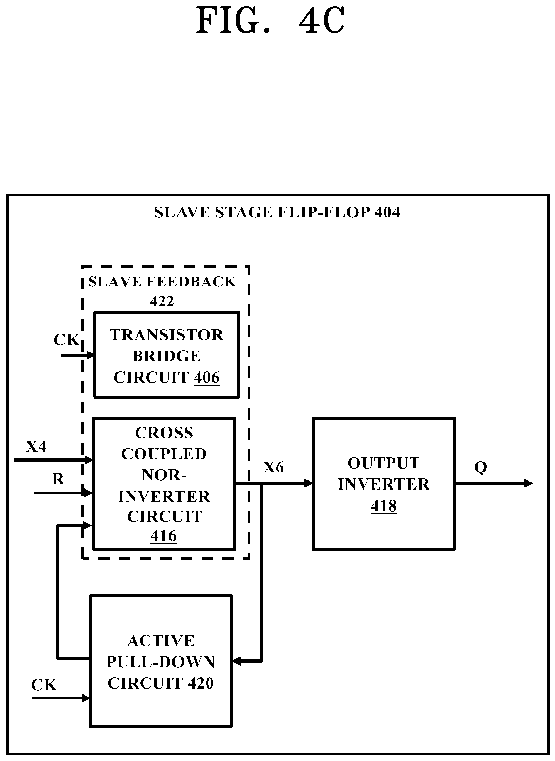

FIG. 4C illustrates a block diagram for slave stage flip-flop 404 in a reset flip-flop circuit, according to embodiments. The slave stage flip-flop 404 comprises the cross-coupled NOR-inverter circuit 416 coupled with a transistor bridge circuit 406 in the pull-up network, followed by an output inverter 418 and an active pull-down circuit 420 in the pull-down network. At a high phase of the clock signal CK, the cross-coupled NOR-inverter circuit 416 coupled with the transistor bridge circuit 406 receives the buffered data output X4 of the master stage flip-flop 402 as the input. The cross-coupled NOR-inverter circuit 416 generates an output using the received buffered data output X4 from the master stage flip-flop 402 during the high phase of the clock signal CK. During high phase of the clock signal CK, the active pull-down circuit 420 discharges one of the nodes X5 or X6 to zero based on the state of buffered data output X4 and buffered inverted data output X3 from the master stage flip-flop 402. At an active high phase of the clock signal CK, the output inverter 418 inverts the output (X6) generated by the cross coupled NOR-inverter circuit 416 to generate a final output Q.

In an embodiment, based on the logic state of the buffered data output X4, the output of the cross-coupled NOR-inverter circuit 416 is controlled by the master stage flip-flop 402. The cross-coupled NOR-inverter circuit 416 holds the state of the buffered data output until the buffered data output changes its state from the previous state. For example, if the cross-coupled NOR-inverter circuit 416 holds the output X6 as 0 (X5 as 1) and the buffered data output X4 changes the state from 1 to 0, the cross coupled NOR-inverter circuit 416 output X6 also changes the state from 0 to 1, when clock signal transitions from low to high state, as the active pull-down circuit 420 discharges the node X5 to zero and eventually inverts the X6 to 1 using IN3 inverter.

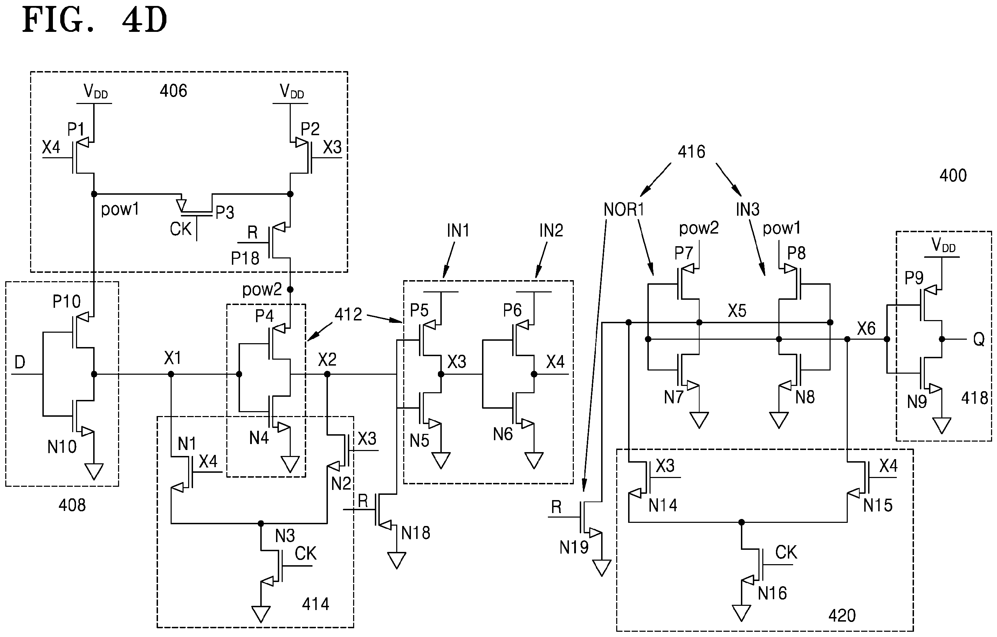

FIG. 4D shows an example schematic of a reset flip-flop 400 for a low power integrated circuit IC) in a standard cell library, according to embodiments. The transistor bridge circuit 406 comprises three PMOS P1, P2 and P3 respectively. The sources of the PMOS P1 and the PMOS P2 are connected to a supply voltage VDD (i.e., "connected to receive VDD" via connection to a node / terminal that supplies VDD). The PMOS P3 is connected as a bridge between the drains of the PMOS P1 and the PMOS P2. The PMOS P3 receives a clock input at a gate to trigger (e.g., turn on at a clock edge transition) the PMOS P3.

In an embodiment, the input data-controlled inverter 408 includes a pull-up transistor. The pull-up transistor includes a PMOS P10, which has its source connected to the drain of a PMOS P1. The input data-controlled inverter 408 further includes a pull-down transistor exemplified as an NMOS N10, whose source is grounded. The gates of P10 and N10 are connected in common to receive the input data D to the master stage flip-flop 402. The gates of P10 and N10 receive the input D when the clock signal CK from the transistor bridge 406 is in active low phase. The drains of the PMOS P10 and NMOS N10 are connected together in common output node, to provide an inverted data as a first output X1 of the input data-controlled inverter 408.

The multistage cascaded controlled NOR-inverting circuit 412 with reset functionality includes a clock and a reset enabled NOR gate cascaded in series with a buffer. The clock and the reset enabled NOR gate includes a series connection of PMOS P18 with another PMOS P4, for generating a pull-up path. The source of the PMOS P18 is connected to a drain of the PMOS P2. The NMOS N4 and NMOS N18 are connected in parallel forming a pull-down path. The drain of NMOS18 is connected to the drain of NMOS N4. The sources of the NMOS N4 and NMOS N18 are grounded. The gates of PMOS18 and NMOS18 are configured to receive the reset signal R.

In an embodiment, a gate of the PMOS P4 in the pull-up path and gate of the NMOS N4 in the pull-down path are connected in common to the output X1 of the input data-controlled inverter 308. The gates of the PMOS P4 and the NMOS N4 receive input from the input data-controlled inverter 408, when the reset signal R is low. The drain of the PMOS P4 and the NMOS N4 are connected in common and provide an inverted data as an output X2 when the reset signal R is low during low phase of the clock signal CK. When the PMOS P18 (e.g. the gate of NMOS N18) receives a reset signal as active high during the low phase of the clock signal CK, the drains of the PMOS P4 and the NMOS N4 provide an active low signal as the output X2. In an embodiment, the multistage cascaded controlled NOR-inverting circuit 412 includes inverters IN1 and IN2 in series, also referred to herein as buffer inverters. The output X2 is provided to the buffer inverters IN1 and IN2, forming a cascading connection of one or more inverters generating the output of the master stage flip-flop 402.

In an embodiment, the inverter IN1 includes a PMOS P5 and an NMOS N5. The source of the PMOS P5 is connected to the source supply voltage VDD and the source of the NMOS N5 is grounded. A gate of the PMOS P5 and a gate of the NMOS N5 are connected in common to the output X2 of the clock-controlled NOR circuit. The drains of the PMOS P5 and the NMOS N5 are connected in common and provide buffered inverted data as the output X3 of the inverter IN1.

In an embodiment, the inverter IN2 includes a PMOS P6 and an NMOS N6. The source of the PMOS P6 is connected to the source supply voltage VDD and the source of the NMOS N6 is grounded. A gate of the PMOS P6 and the NMOS N6 are connected in common to the output X3 of the inverter IN1. The drain of the PMOS P6 and the NMOS N6 are connected in common and provide inverted data as the output X4 of the inverter IN2. The inverter IN2 provides the output X4 at the low phase of the clock signal CK. The output X4 is the final buffered data output of the master stage flip-flop 402.

In an embodiment, the output of the inverter IN1 and inverter IN2 are given as inputs to the gates of the PMOS P1 and the PMOS P2 of the transistor bridge circuit 406. The PMOS P1 and the PMOS P2 receive X4 and X3 as an input at the gates of PMOS P1 and the PMOS P2, respectively. X3 and X4 are the outputs generated from the last two inverters IN1 and IN2 of the multistage cascaded controlled NOR-inverting circuit 412. One of the outputs X3, X4 may always be active high, therefore, at least one of the PMOS P1 and the PMOS P2 is in an active state irrespective of the clock signal CK, keeping the transistor bridge circuit ON.

In an embodiment, a master feedback circuit 414 includes two pull-down paths. A first pull-down path includes an NMOS N1 connected in series with an NMOS N3. A second pull-down path includes an NMOS N2 connected in series with the NMOS N3. The sources of the NMOS N1 and the NMOS N2 are connected in common in series with the drain of NMOS N3. The gate of the NMOS N3 is connected to the clock signal CK. The drain of the NMOS N1 is connected to the output X1 of the input data-controlled inverter 408. The drain of the NMOS N2 is connected to the output X2 of the clock-controlled NOR-inverter of the multistage cascaded controlled NOR-inverting circuit 412. The gate of the NMOS N1 is connected to the buffered output X4 generated by the buffer inverter IN2. The gate of the NMOS N2 is connected to the buffered inverting output X3 of the inverter IN1. As one of the buffered outputs X3 and X4 is always one, at least one of the NMOS N2 and NMOS N1 is ON irrespective of the phase of the clock signal CK. During high phase of the clock signal CK, the master feedback circuit 414 provides the output of the previous state as the feedback, during the previous low phase of the clock signal CK.

The NOR gate is enabled with a reset signal R, and coupled in series with a buffer to reset the master stage output from a received high asynchronous reset signal R provided at the input port of the flip-flop by resetting the output X2 of the controlled NOR circuit to zero.

In an embodiment, the cross-coupled NOR-inverter circuit 416 includes an inverter IN3 and a NOR gate NOR1 connected back to back. The drain of a PMOS P7 and the drain of an NMOS N7 of the NOR gate NOR1 are connected in common to the gate a PMOS P8 and the gate of an NMOS N8 of the inverter IN3, which are connected in common. Also, the drains of the PMOS P7 and the NMOS N7 of the NOR gate NOR1 are connected in common to a drain of an NMOS N19 of the NOR gate NOR1. A source of the NMOS N19 is grounded. The gate of the NMOS N19 receives the asynchronous reset R signal. The drain of the PMOS P8 and the drain of the NMOS N8 of the inverter IN3 are connected in common to the gate the PMOS P7 and gate of the NMOS N7 of the NOR gate NOR1 connected in common.

The gates of the inverter IN3 and NOR1 are driven by two pull-down paths of the active pull-down circuit 420. The first pull-down path comprises an NMOS N14 connected in series with another NMOS N16. A second pull-down path comprises an NMOS N15 in series with the NMOS N16. The sources of the NMOS N14 and the NMOS N15 are connected in common, in series with a drain of the NMOS N16. The source of the NMOS N16 is grounded. The gate of the NMOS N16 is connected to the clock signal CK. The gate of the NMOS N14 is connected to the buffered inverted output X3 from the inverter IN1 of the multistage cascaded controlled NOR-inverting circuit 412. The gate of the NMOS N15 is connected to the buffered output X4 from the inverter IN2 of the multistage cascaded controlled NOR-inverting circuit 412.

In an embodiment, the drain of the NMOS N14 is connected to the drain of the NOR gate NOR1 (e.g. the drains of PMOS P7, NMOS N7 and NMOS N18) and the gate of the inverter IN3 (e.g. the gates of PMOS P8 and NMOS N8). The drain of the NMOS N15 is connected to the drain of IN3 (e.g. the drains of PMOS P8 and NMOS N8) and the gate of NOR1 (e.g. the gates of PMOS P7 and NMOS N7).

In an embodiment, the cross-coupled NOR-inverter circuit 416 generates the final output through the output inverter 418 (formed by a PMOS P9 and an NMOS N9 connected in the same manner as P10 and N10) using the received buffered data output from the master stage flip-flop 402 during the high phase (high voltage level) of the clock signal CK. The master stage flip-flop 402 controls the output of the cross-coupled NOR-inverter circuit 416 based on the logic state of the received master stage output X4.

In an embodiment, the buffer output of the master stage flip-flop 402 follows the input provided to the input data-controlled inverter 408, at the low phase of the clock signal CK. When the clock signal CK is detected as high, the master feedback circuit 414 becomes activated to hold the last buffer state present in the previous low phase of the clock signal CK.

In an embodiment, the slave stage flip-flop 404 conducts (e.g. conducts or outputs a signal) on receiving a positive edge of the clock signal CK. Based on the master stage flip-flop 402 output X4, the slave stage flip-flop 404 controls the state of final output Q. In an embodiment, the cross-coupled NOR-inverter circuit 416 coupled with transistor bridge circuit 406 in the pull-up path holds a previous final output Q' when the clock signal CK is zero, and the previous final output Q' acts as the feedback to the slave stage flip-flop 404. The NOR gate is enabled with the received high asynchronous reset signal R provided at the input port of the flip-flop by resetting the output of flip-flop to zero.

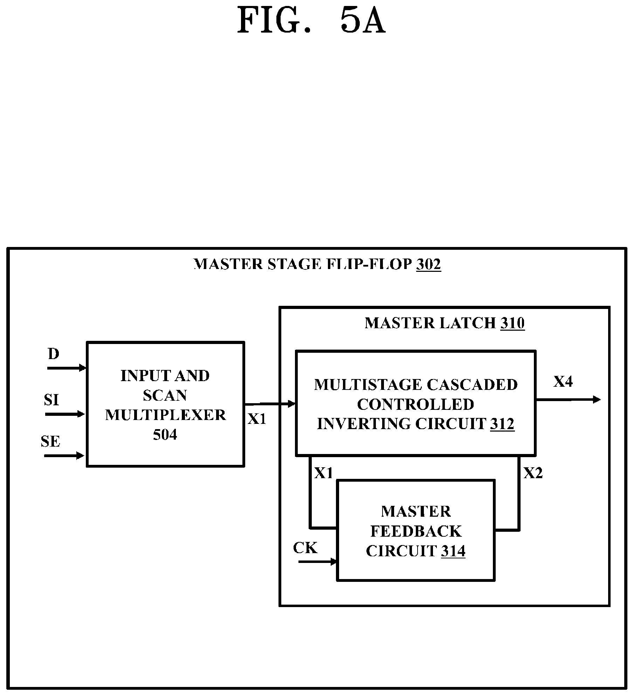

FIG. 5A illustrates a block diagram of a master stage flip-flop 302, for a flip-flop with scan functionality for a low power integrated circuit (IC), according to embodiments. The flip-flop with scan functionality includes a master stage flip-flop 302, a slave stage flip-flop 304, and a transistor bridge circuit 306. The transistor bridge circuit 306 can share the clock signal CK between the master stage flip-flop 302 and the slave stage flip-flop 304.

In an embodiment, the master stage flip-flop 302 includes an input and scan multiplexer 504, a master latch 310 which includes a multistage cascaded controlled inverting circuit 312, and a master feedback circuit 314. The master stage flip-flop 302 may receive at least one of a data signal as an input on the input pin of the scan and input multiplexer 504 based on a state of a scan enable pin (SE) of the input and scan multiplexer 504. The master stage flip-flop 302 may receive at least one of the scan input (SI) signal as the input based on the state of the scan enable pin of the input and scan multiplexer 504.

In an embodiment, the input and scan multiplexer 504 may generate the inverted signal from at least one of an input data D and the scan input data SI based on the state of the scan enable signal SE received at the input ports of the flip-flop during the low phase of the clock signal CK. If the scan enables signal SE of the input and scan multiplexer 504 is high, the input and scan multiplexer 504 may receive a scan input data SI, during a low phase of the clock signal CK. The input and scan multiplexer 504 can generate an inverted output from the received scan input. When the scan enable signal SE is low, the input and scan multiplexer 504 may receive a normal input data D without the scan functionality. The input and scan multiplexer 504 can generate an inverted output from the received input data D. Upon receiving normal input data, the flip-flop may work as a normal D flip-flop without scan functionality.

In an embodiment, the multistage cascaded controlled inverting circuit 312 receives the inverted data input or the inverted scan input from the output of the input and the scan multiplexer 504, at low phase of the clock signal CK. The multistage cascaded controlled inverting circuit 312 may generate the output of master stage in the form of scan buffered data output X4 from the received inverted data input. The scan buffered data output X4 generated at the low phase of the clock signal CK acts as the input to the slave stage flip-flop 304.

In an embodiment, the master stage feedback circuit 314 is active when the clock signal CK is high. The master feedback circuit 314 provides the first internal feedback in the form of the previous master stage output generated during the previous low phase of the clock signal CK.

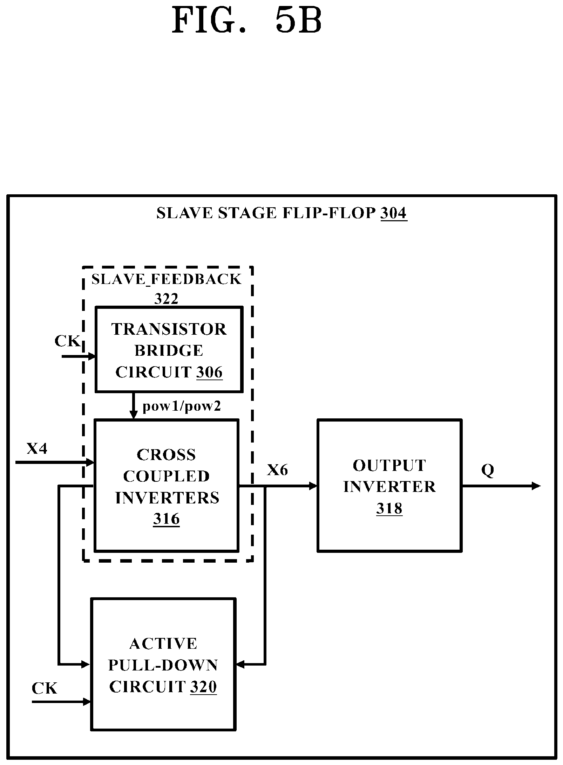

FIG. 5B illustrates a block diagram for a slave stage flip flop 304 in a flip-flop circuit with scan functionality, according to embodiments. The slave stage flip-flop 304 comprises the cross-coupled inverters 316 coupled with the transistor bridge circuit 306 in the pull-up network, followed by an output inverter 318 and an active pull-down circuit 320 in the pull-down path. The cross coupled inverters 316 receive the scan buffered data output X4 of the master stage flip-flop 302 as the input, at a high phase of the clock signal CK. The cross-coupled inverters 316 along with active pull-down circuit 320 generate an output using the received scan buffered data output X4 from the master stage flip-flop 302 during the high phase of the clock signal CK. The output inverter 318 inverts the output generated by the cross coupled inverters 316 to generate a final output Q, at an active high phase of the clock signal CK.

In an embodiment, the output of the cross-coupled inverters 316 is controlled by the master stage flip-flop 302 based on the logic state of the scan buffered output X4. The cross-coupled inverters 316 hold the state of the scan buffered output until the scan buffered output changes its state from the previous state. For example, if the cross-coupled inverters 316 hold the output X6 as 0 (X5 as 1) and the scan buffered output X4 changes the state from 1 to 0, the output X6 of the cross coupled inverters 316 changes the state from 0 to 1, when clock transitions from low to high signal, as the active pull-down circuit 320 becomes active and discharges the X5 node to 0 and IN4 inverter inverts the X6 signal to 1 and thus the final output Q to 0.

In an embodiment, the slave feedback circuit 422 provides the second internal feedback, through the transistor bridge circuit 306 in the pull-up path at a low phase of the clock signal CK. The second internal feedback comprises a previous slave stage output during previous high phase of the clock signal CK.

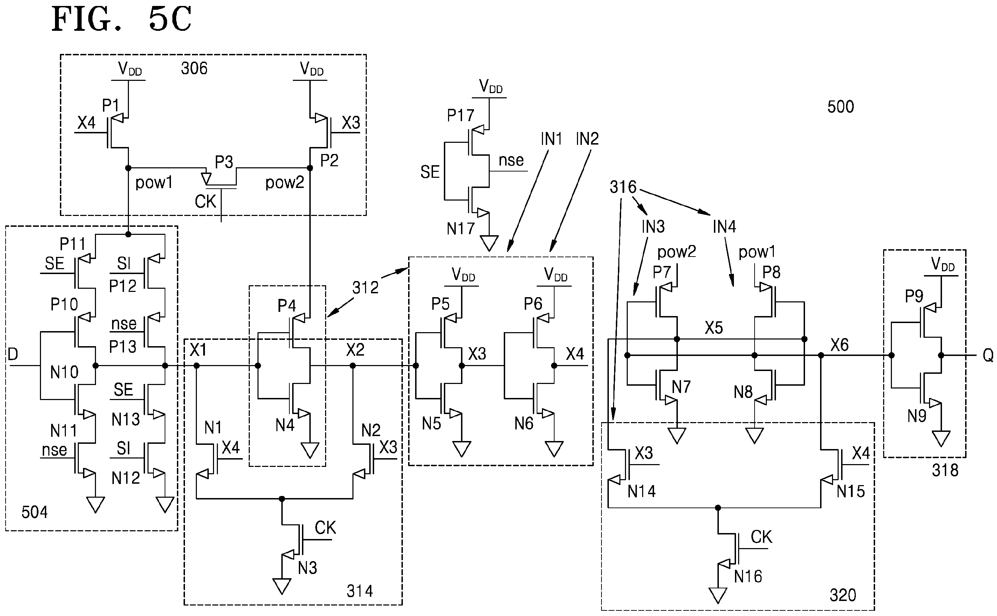

FIG. 5C shows an example of a schematic of a flip flop with scan functionality 500 for a low power integrated circuit IC in a standard cell library, according to embodiments. The transistor bridge circuit 306 comprises three PMOS transistors P1, P2 and P3 respectively. The sources of the PMOS P1 and the PMOS P2 are connected to a supply voltage VDD. The PMOS P3 is connected as a bridge between drains of the PMOS P1 and the PMOS P2. The PMOS P3 receives a clock input at a gate to trigger the PMOS P3.

In an embodiment, the input and scan multiplexer 504 includes a pull-up circuit and a pull-down circuit. A source of each of a PMOS P11 and a PMOS P12 of the pull-up circuit is connected to a drain of the PMOS P1 of the transistor bridge circuit 306. The pull-up circuit of the input and scan multiplexer 504 includes a series connection of a PMOS P10 and the PMOS P11. The series connection of the PMOS P10 and the PMOS P11 is connected in parallel with another series connection of the PMOS P12 and a PMOS P13. The pull-down circuit may include a series connection of an NMOS N10 and an NMOS N11. The series connection of the NMOSs N10 and N11 is connected in parallel with another series connection of an NMOS N12 and an NMOS N13. The sources of the NMOSs N11 and N12 are grounded. The drains of PMOS P10 and PMOS P13 are connected to the drains of NMOS N10 and NMOS N13.

In an embodiment, the input and scan multiplexer 504 may provide the input SE of a scan enable pin to the PMOS P11 (e.g. to the gate of the PMOS P11) and an inverted scan enable to the NMOS N11 (e.g. to the gate of the NMOS N11). The scan inverted enable signal nse is generated using a CMOS inverter including a PMOS P17 and an NMOS N17 where the gates of both N17 and P17 are connected in common to a node receiving the scan enable signal SE, and the drains of both N17 and P17 are connected in common to a node for outputting nse. The input and scan multiplexer 504 generates the scan inverted output based on the state of scan input SI, when the scan enable signal SE is high and provides the output to the master latch 310. The scan input SI is provided at the PMOS P12 and the NMOS N12 (e.g. at the gates of PMOS P12 and NMOS N12). The output of the input and scan multiplexer 504 is X1.

In an embodiment, the multistage cascaded controlled inverting circuit 312 includes a clock-controlled inverter that may include a PMOS P4 and an NMOS N4. The source of the PMOS P4 is connected to a drain of the PMOS P2 of the bridge circuit. A gate of the PMOS P4 and the NMOS N4 are connected in common to the output X1 of the input and scan multiplexer 504. The multistage cascaded controlled inverting circuit 312 receives input from the input and scan multiplexer 504. The drain of the PMOS P4 and the NMOS N4 are connected in common and provide inverted data as the output X2 of clock-controlled inverter.

In an embodiment, the multistage cascaded controlled inverting circuit 312 includes inverters IN1 and IN2 cascaded in series also known as buffer inverters.

In an embodiment, the inverter IN1 includes a PMOS P5 and an NMOS N5. The source of the PMOS P5 is connected to the source supply voltage VDD and the source of the NMOS N5 is grounded. A gates of the PMOS P5 and the NMOS N5 are connected in common to the output X2 of the clock-controlled inverter. The drains of the PMOS P5 and the NMOS N5 are connected in common and provide inverted data as the scan buffered inverted output X3 of the inverter IN1.

In an embodiment, the inverter IN2 includes a PMOS P6 and an NMOS N6. The source of the PMOS P6 is connected to the source supply voltage VDD and the source of the NMOS N6 is grounded. A gates of the PMOS P6 and the NMOS N6 are connected in common to the output X3 of the inverter IN1. The drains of the PMOS P6 and the NMOS N6 are connected in common and provide invert of X3 data as the output X4 of the inverter IN2. The inverter IN2 provides the scan buffered output X4 at the low phase of the clock signal CK. The output X4 is the final scan buffered data output of the master stage flip-flop 302.

In an embodiment, the output of the inverter IN1 and inverter IN2 are given as inputs to the gates of the PMOS P1 and the PMOS P2 of the transistor bridge circuit 306. The PMOS P1 and the PMOS P2 receive X4 and X3 as inputs at the gates of PMOS P1 and the PMOS P2, respectively. X3 and X4 are the outputs generated from the last two inverters IN1 and IN2 of multistage cascaded controlled inverting circuit 312 Any of the one output X3 and X4 may always be active high, therefore, at least one of the PMOS P1 and the PMOS P2 is in an active state irrespective of the clock signal CK.

In an embodiment, a master feedback circuit 314 includes two pull-down paths. And at least one pull-down path includes an NMOS N1 connected in series with an NMOS N3 and a second pull-down path includes an NMOS N2 connected in series with the NMOS N3. The source of the NMOS N1 and the NMOS N2 are connected in common in series with the drain of NMOS N3. The gate of the NMOS N3 is connected to the clock signal CK. The NMOS N1 is connected to the output X1 of the input and scan multiplexer 504. The drain of the NMOS N2 is connected to the output X2 of the clock-controlled inverter of the multistage cascaded inverting circuit 312. The gate of the NMOS N1 is connected to the scan buffered output X4 generated by the buffer inverter IN2, and the gate of the NMOS N2 is connected to the buffered inverting output X3 of the inverter IN1. As one of the scans buffered output X3 and X4 is always one, at least one of the NMOS N2 and the NMOS N1 is ON irrespective of the phase of the clock signal CK. The master stage feedback circuit 314 provides the output of the previous state as the feedback, present in the previous low phase of the clock signal CK.

In an embodiment, the cross-coupled inverters 316 includes two inverters IN3 and IN4 connected back to back. The drains of a PMOS P7 and an NMOS N7 of the inverter IN3 are connected in common to the gates of a PMOS P8 and an NMOS N8 of the inverter IN4, connected in common. The drains of the PMOS P8 and the NMOS N8 of the inverter IN4 are connected in common to the gates of the PMOS P7 and the NMOS N7 of the inverter IN3, connected in common. The gates of the inverter IN3 and IN4 are driven by two pull-down paths of the active pull-down circuit 320. The first pull-down path comprises an NMOS N14 connected in series with another NMOS N16 and a second pull-down path comprises an NMOS N15 connected in series with the NMOS N16. The sources of the NMOS N14 and the NMOS N15 are connected in common, in series with a drain of the NMOS N16. The source of the NMOS N16 is grounded. The gate of the NMOS N16 is connected to the clock signal CK. The gate of the NMOS N14 is connected to the buffered inverted output X3 from the inverter IN1 of multistage cascaded controlled inverting circuit 312. The gate of the NMOS N15 is connected to the buffered output X4 from the inverter IN2 of multistage cascaded controlled inverting circuit 312.

In an embodiment, the drain of the NMOS N14 is connected to the drain of the inverter IN3 (e.g. the drains of PMOS P7 and NMOS N7) and the gate of inverter IN4 (e.g. the gates of PMOS P8 and NMOS N8). The drain of the NMOS N15 is connected to the drain of the inverter IN4 (e.g. the drains of PMOS P8 and NMOS N8) and the gate of inverter IN3 (e.g. the gates of PMOS P7 and NMOS N7).

In an embodiment, the cross-coupled inverters 316 coupled with the active pull-down circuit 320 generates the final output Q through the output inverter 318 using the received scan buffered output from the master stage flip-flop 302 during high phase of the clock signal CK; wherein the master stage flip-flop 302 controls the output of the cross-coupled inverters 316 based on the logic state of the received master stage output X4.

In an embodiment, the buffer output of the master stage flip-flop 302 follows the input to the input and scan multiplexer 504, at low phase of the clock signal CK. The master feedback circuit 314 becomes activated to hold the last buffer state at the previous low phase of the clock signal CK, when the clock signal CK is detected as high.

In an embodiment, the slave stage flip-flop 304 conducts (e.g. conducts or outputs a signal) on receiving a positive edge of the clock signal CK. The slave stage flip-flop 304 based on the master stage flip-flop output X4 controls the state of final output Q. In an embodiment, the cross-couple inverters 316 coupled with transistor bridge circuit 306 in the pull-up path holds a previous final output Q' when the clock signal CK is zero, and the previous final Q' output acts as the feedback to the slave stage flip-flop 304.

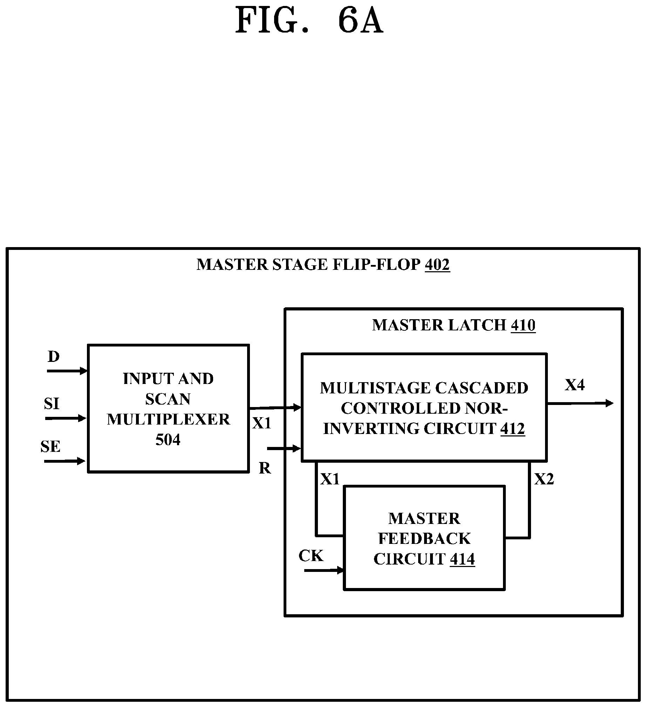

FIG. 6A illustrates a block diagram of a master stage flip-flop 402, for a reset flip-flop with scan functionality for a low power integrated circuit (IC), according to embodiments. The reset flip-flop with scan functionality includes a master stage flip-flop 402, a slave stage flip-flop 404, and a transistor bridge circuit 406 for sharing a clock signal CK between the master stage flip-flop 402 and the slave stage flip-flop 404.

In an embodiment, the master stage flip-flop 402 includes an input and scan multiplexer 504, and a master latch 410 including a multistage cascaded controlled NOR-inverting circuit 412, and a master feedback circuit 414. The master stage flip-flop 402 receives at least one of a data signal as an input on the input port based on a state of a scan enable pin of the input and scan multiplexer 504 and the scan input signal as the input based on the state of the scan enable pin of the input and scan multiplexer 504.

In an embodiment, the input and scan multiplexer 504 may generate the inverted signal from at least one of an input data and the scan input data based on the state of the scan enable signal received at the input ports of the reset flip-flop during low phase of the clock signal CK. If the scan enables signal of the input and scan multiplexer 504 is high, the input and scan multiplexer 504 may receive a scan input data, during a low phase of the clock signal CK. The input and scan multiplexer 504 generate an inverted output X1 from the received scan input. When the scan enable signal is low, the input and scan multiplexer 504 may receive a normal input data without the scan functionality. The input and scan multiplexer 504 generate an inverted output from the received input data. Upon receiving normal input data, the flip-flop may work as a normal D flip-flop without scan functionality. The reset flip-flop may receive an asynchronous reset signal as an input on the input port of the flip-flop, that resets the final output Q of the reset flip-flop with scan functionality as zero.

In an embodiment, the multistage cascaded controlled NOR-inverting circuit 412 receives the inverted data input or the inverted scan input from the output of the input and scan multiplexer 504, at a low phase of the clock signal CK. The multistage cascaded controlled NOR-inverting circuit 412 may generate the output of master stage in a form of scan buffered data output X4 from the received inverted data/scan input. The scan buffered data output X4 generated at the low phase of the clock signal CK acts as the input to the slave stage flip-flop 404.

In an embodiment, the multistage cascaded controlled NOR-inverting circuit 412 with reset functionality receives an inverted data input or the inverted scan input from the output of the input and scan multiplexer 504, through a NOR gate, at a low phase of the clock signal CK. The multistage cascaded controlled NOR-inverting circuit 412 may generate the output of master stage in a form of scan buffered data output X4 from the received inverted scan data input. The NOR gate is enabled with a reset signal coupled in series with a buffer to reset the master stage output from a received high asynchronous reset signal provided at the input port of the flip-flop by resetting the output of controlled NOR circuit to zero.

In an embodiment, the master stage feedback circuit 414 is active when clock signal CK is high. The master feedback circuit 414 provides the first internal feedback in the form of the previous master stage output generated during previous low phase of the clock signal CK.

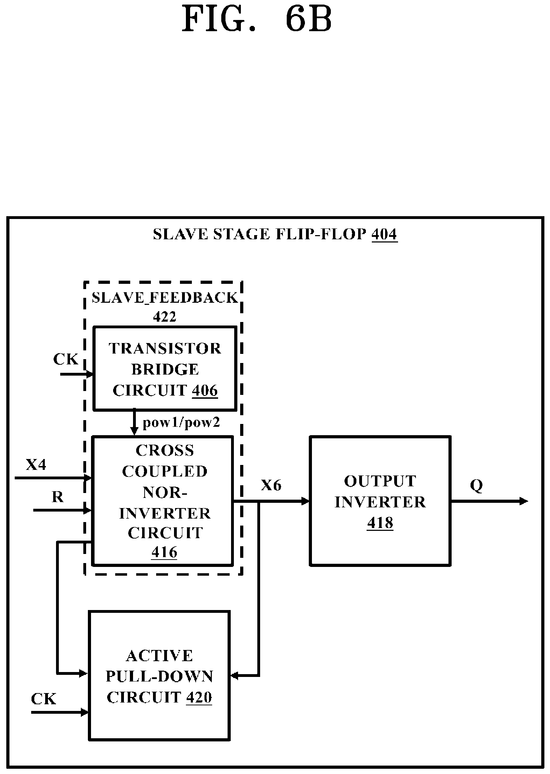

FIG. 6B illustrates a block diagram for slave stage flip-flop 404 in a reset flip-flop circuit with scan functionality, according to embodiments. The slave stage flip-flop 404 comprising the cross-coupled NOR-inverter circuit 416 coupled with the transistor bridge circuit 406 in the pull-up network, followed by an output inverter 418 and an active pull-down circuit 420 in the pull-down network. The cross-coupled NOR-inverter circuit 416 receives the scan buffered data output X4 of the master stage flip-flop 402 as the input, at a high phase of the clock signal CK. The cross-coupled NOR-inverter coupled with active pull-down circuit 420 generates an output using the received scan buffered data output X4 from the master stage flip-flop 402 during high phase of the clock signal CK. During high phase of the clock signal CK, the active pull-down circuit 420 discharges one of the nodes X5 or X6 to zero based on the state of buffered data output X4 and buffered inverted data output X3 from the master stage flip-flop 402. The output inverter 418 inverts the output generated by the cross-coupled NOR-inverter circuit 416 to generate a final output Q, at an active high phase of the clock signal CK.

In an embodiment, the output of the cross-coupled NOR-inverter circuit 416 is controlled by the master stage flip-flop 402 based on the logic state of the scan buffered data output X4 and the clock signal CK. The cross-coupled NOR-inverter circuit 416 holds the state of the scan buffered data output until the buffered data output changes its state from the previous state. For example, if the cross-coupled NOR-inverter circuit 416 holds the output X6 as 0 (X5 as 1) and the scan buffered data output X4 changes the state from 1 to 0, the output of cross coupled inverter circuit 416, X6 also changes the state from 0 to 1, when clock transitions from low to high. The active pull-down circuit discharges X5 to 0 and inverter IN3 inverts the state of X6 to 1 and eventually changes the final output Q.

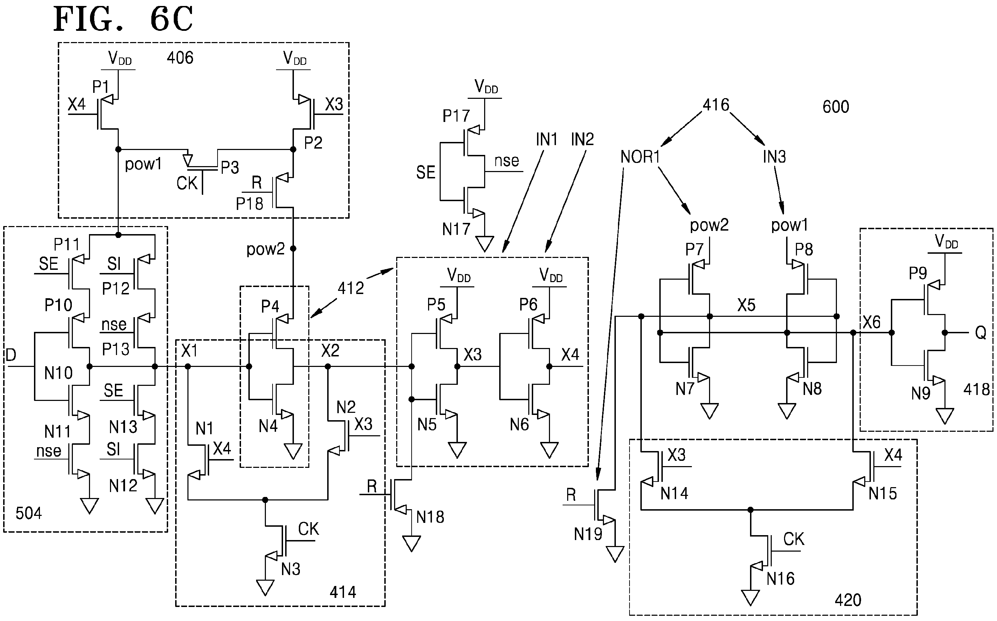

FIG. 6C shows an example of a schematic of a reset flip-flop 600 with scan functionality for a low power integrated circuit IC in a standard cell library, according to embodiments. The transistor bridge circuit 406 comprises three PMOS transistors P1, P2 and P3 respectively. The sources of P1 and P2 are connected to receive a supply voltage VDD. The PMOS P3 is connected as a bridge between the drains of P1 and P2. The PMOS P3 receives a clock input at its gate to trigger P3.

In an embodiment, the input and scan multiplexer 504 includes a pull-up circuit and a pull-down circuit. A source of each of a PMOS P11 and a PMOS P12 of the pull-up circuit is connected to a drain of the PMOS P1 of the bridge circuit 406. The pull-up circuit of the input and scan multiplexer 504 includes a series connection of a PMOS P10 and another PMOS P11. The series connection of the PMOS P10 and the PMOS P11 is connected in parallel to a series connection of the PMOS P12 and a PMOS P13. The pull-down circuit comprises a series connection comprising an NMOS N10 and NMOS N11. The series connection of the NMOS N10 and the NMOS N11 is connected in parallel to a series connection of an NMOS N12 and an NMOS N13. The sources of the NMOS N11 and the NMOS N12 are grounded. The drains of PMOS P10 and PMOS P13 are connected to the drains of NMOS N10 and NMOS N13.

In an embodiment, the input and scan multiplexer 504 may provide the input of a scan enable pin to the PMOS P11 (e.g. to the gate of the PMOS P11) and an inverted scan enable to the NMOS N11 (e.g. to the gate of the NMOS N11). The scan inverted enable (nse) signal is used to generate a CMOS inverter including PMOS P17 and NMOS N17 where the gates of both N17 and P17 are connected in common node receiving the scan enable signal (SE) and the drains of both N17 and P17 is connected in common node for outputting the inverted scan enable signal (nse). The input and scan multiplexer 504 may generate the scan inverted output X1 based on the state of first scan input SI, when the scan enable (SE) signal is high and provide the output to the master latch. The first scan input SI is provided at the PMOS P12 and the NMOS N12 (e.g. at the gates of PMOS P12 and NMOS N12).

The multistage cascaded controlled NOR-inverting circuit 412 with reset functionality includes a clock and a reset enabled NOR gate cascaded in series with a buffer. The clock and the reset enabled NOR gate includes a series connection of PMOS P18 with a PMOS P4, in a pull-up path. The source of the PMOS P18 is connected to a drain of the PMOS P2 of the transistor bridge circuit 406. The NMOS N4 is connected in parallel to an NMOS N18 forming a pull-down path. The drain of NMOS18 is connected to the drain of NMOS N4. The sources of the NMOS N4 and NMOS N18 are grounded. The gates of PMOS18 and NMOS18 are configured to receive the reset signal R.

In an embodiment, a gate of the PMOS P4 in the pull-up path and the NMOS N4 in the pull-down path are connected in common to the output of the input and scan multiplexer 504 and receive input from the input and scan multiplexer 504, when the reset signal R is low. The drains of the PMOS P4 and the NMOS N4 are connected in common and provide an inverted data as an output X2 when the reset signal R is low. When the NMOS N18 (e.g. the gate of NMOS N18) receives a reset signal as active high, the drain of the PMOS P4 and the NMOS N4 provide an active low signal as the output. The output X2 of the multistage cascaded controlled NOR-inverting circuit with reset functionality 412 is provided to the buffer IN1 and IN2, wherein a cascading connection of one or more inverters generate the buffered output X4 of the master stage flip-flop 402.

In an embodiment, the multistage cascaded NOR-inverting circuit 412 includes inverters IN1 and IN2 in series, also referred to herein as buffer inverters.

In an embodiment, the inverter IN1 includes a PMOS P5 and an NMOS N5. The source of the PMOS P5 is connected to the source supply voltage VDD. The source of the NMOS N5 is grounded. A gate of the PMOS P5 and the NMOS N5 are connected in common to the output X2 of the clock-controlled NOR. The drains of the PMOS P5 and the NMOS N5 are connected in common and provide buffered inverted data as the output X3 of the inverter IN1.

In an embodiment, the inverter IN2 includes a PMOS P6 and an NMOS N6. The source of the PMOS P6 is connected to the source supply voltage VDD and the source of the NMOS N6 is grounded. A gate of the PMOS P6 and the NMOS N6 are connected in common to the output X3 of the inverter IN1. The drain of the PMOS P6 and the NMOS N6 are connected in common and provide inverted data as the output X4 of the inverter IN2. The inverter IN2 provides the output X4 at the low phase of the clock signal CK. The output X4 is the final buffered data output of the master stage flip-flop 402.

In an embodiment, the output of the inverter IN1 and inverter IN2 are given as inputs to the gates of the PMOS P1 and the PMOS P2 of the transistor bridge circuit 406. The PMOS P1 and the PMOS P2 receive X4 and X3 as an input at the gates of PMOS P1 and the PMOS P2, respectively. X3 and X4 are the outputs generated from the last two inverters IN1, IN2 of multistage cascaded controlled NOR-inverting circuit 412. One of the outputs X3, X4 may always be active high, therefore, at least one of the PMOS P1 and the PMOS P2 is in an active state irrespective of the clock signal CK, thereby keeping the transistor bridge circuit ON.

In an embodiment, a master feedback circuit 414 includes two pull-down paths. A first pull-down path includes an NMOS N1 connected in series with an NMOS N3. A second pull-down path includes an NMOS N2 connected in series with the NMOS N3. The source of the NMOS N1 and the NMOS N2 are connected in common in series with the drain of NMOS N3. The gate of the NMOS N3 is connected to the clock signal CK. The drain of NMOS N1 is connected to the output X1 of the input and scan multiplexer 504. The drain of the NMOS N2 is connected to the output X2 of the clock-controlled NOR gate of the multistage cascaded controlled NOR-inverting circuit 412. The gate of the NMOS N1 is connected to the buffered output X4 generated by the buffer inverter IN2. The gate of the NMOS N2 is connected to the buffered inverting output X3 of the inverter IN1. As one of the buffered outputs X3 and X4 is always one, at least one of the NMOS N2 and NMOS N1 is ON irrespective of the phase of the clock signal CK. The master stage feedback circuit 414 provides the output of the previous state as the feedback, which was present during previous low phase of the clock signal CK.

The NOR gate is enabled with a reset signal, wherein the NOR gate is coupled in series with a buffer to reset the master stage output from a received high asynchronous reset signal provided at the input port of the flip-flop by resetting the output of clock-controlled NOR circuit to zero.

In an embodiment, the cross-coupled NOR-inverter circuit 416 in the slave stage flip-flop includes an inverter IN3 and a NOR gate NOR1 connected back to back. The drains of a PMOS P7 and an NMOS N7 of the NOR gate NOR1 are connected in common to the gates of a PMOS P8 and an NMOS N8 of the inverter IN3. Also, the drains of the PMOS P7 and the NMOS N7 of the NOR gate NOR1 are connected in common to a drain of an NMOS N19. A source of the NMOS N19 is grounded. The gate of the NMOS N19 receives the asynchronous reset R signal. The drains of the PMOS P8 and the NMOS N8 of the inverter IN3 are connected in common to the gates of the PMOS P7 and the NMOS N7 of the NOR gate NOR1.

A pull-up PMOS transistor P18 with reset signal at its gate is connected in series with the PMOS transistor P7 from the NOR gate NOR1 of the slave stage. The pull-up PMOS transistor P18 is shared between the multistage cascaded controlled NOR-inverting circuit 412 from the master stage and the cross-coupled NOR-inverter circuit 416 from the slave stage. The drain of the pull-up PMOS transistor P18 with reset input from the pull-up path of a NOR gate is connected to the source of the PMOS transistor P7 from the NOR gate in slave stage.

The gates of the inverter IN3 and NOR1 are driven by two pull-down paths of the active pull-down circuit 420. The first pull-down path comprises an NMOS N14 connected in series with another NMOS N16. The second pull-down path comprises an NMOS N15 in series with the NMOS N16. The sources of the NMOS N14 and the NMOS N15 are connected in common, in series with a drain of the NMOS N16. The source of the NMOS N16 is grounded. The gate of the NMOS N16 is connected to the clock signal CK. The gate of the NMOS N14 is connected to the buffered inverted output X3 from the inverter IN1 of the multistage cascaded controlled NOR-inverting circuit 412. The gate of the NMOS N15 is connected to the buffered output X4 from the inverter IN2 of the multistage cascaded controlled NOR-inverting circuit 412.

In an embodiment, the drain of the NMOS N14 is connected to the drain of the NOR gate NOR1 (e.g. the drains of PMOS P7, NMOS N7 and NMOS N19) and the gate of the inverter IN3 (e.g. the gates of PMOS P8 and NMOS N8). The drain of the NMOS N15 is connected to the drain of the inverter IN3 (e.g. the drains of PMOS P8 and NMOS N8) and the gate of NOR gate NOR1 (e.g. the gates of PMOS P7 and NMOS N7).

In an embodiment, the cross-coupled NOR-inverter circuit 416 generates the final output Q through the output inverter 418 using the received buffered data output from the master stage flip-flop 402 during high phase of the clock signal CK. The master stage flip-flop 402 controls the output of the cross-coupled NOR-inverter circuit 416 based on the logic state of the received master stage output.

In an embodiment, the buffer output of the master stage flip-flop 402 follows the input to the input and scan multiplexer 504, at the low phase of the clock signal CK. The master feedback circuit 414 becomes activated to hold the last buffer state at the previous low phase of the clock signal CK, when the clock signal CK is detected as high.

In an embodiment, on receiving a positive edge of the clock signal CK, the slave stage flip-flop 404 conducts (e.g. conducts or outputs a signal). Based on the master stage flip-flop output X4, the slave stage flip-flop 404 controls the state of final output Q. In an embodiment, the cross-coupled NOR-inverter circuit coupled with transistor bridge circuit 406 in the pull-up path holds a previous final output Q' when the clock signal CK is zero, and the previous final output Q' acts as the feedback to the slave stage flip-flop 404. The NOR gate NOR1 is enabled with the received high asynchronous reset signal provided at the input port of the flip-flop by resetting the output of flip-flop to zero.

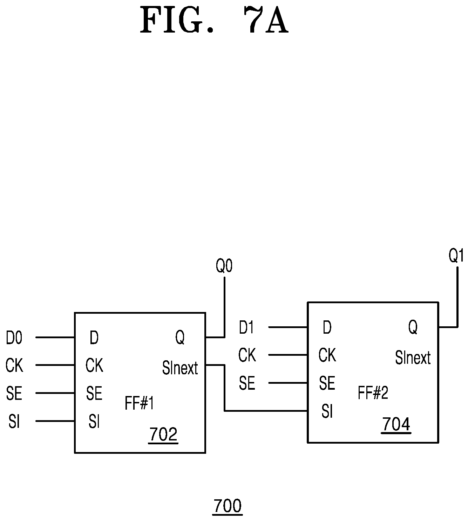

FIG. 7A illustrates a block diagram of a multibit flip-flop with scan functionality for a low power integrated circuit IC in a standard cell library, according to embodiments of the inventive concept. The multibit flip-flop 700 may include a first stage one-bit flip-flop 702 and a second stage one-bit flip-flop 704. The first stage one-bit flip-flop 702 and the second stage one-bit flip-flop 704 use a scan input transfer function in a sequential manner, i.e., the output of the first stage one-bit flip-flop 702 is given as the scan input to the second stage one-bit flip-flop 704. If there are more than two flip-flops, the scan input of the next bit flip-flop is the output of the previous flip-flop, i.e., in a sequential manner.

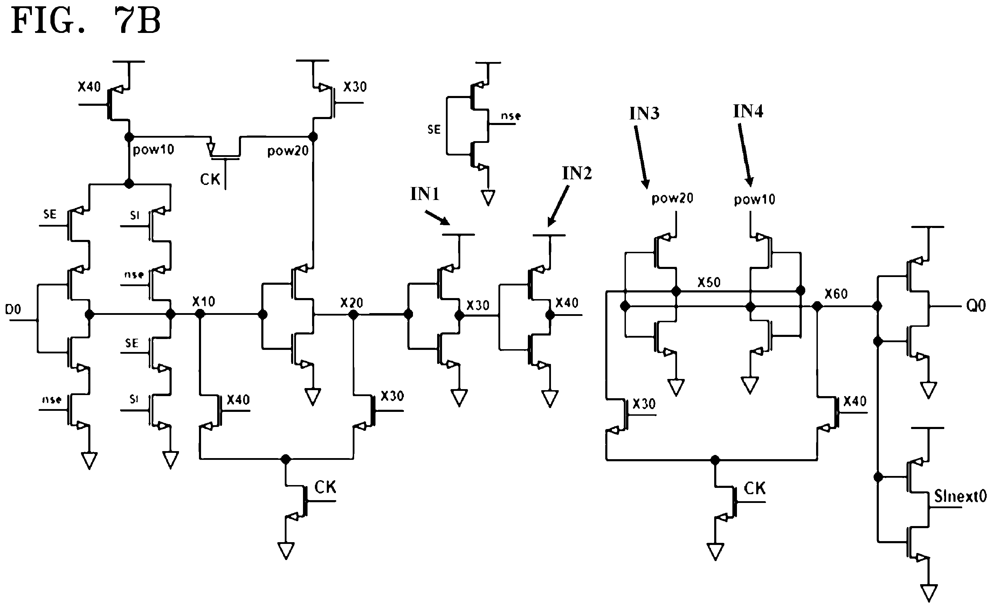

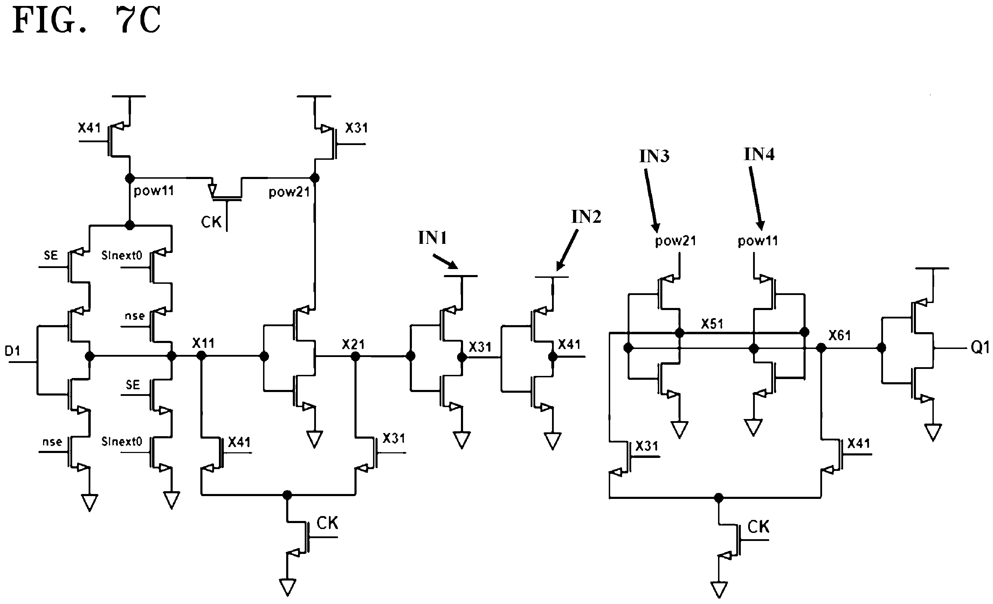

FIGS. 7B and 7C illustrate an example schematic of a multibit flip-flop with scan functionality for a low power integrated circuit (IC) in a standard cell library, according to embodiments of the inventive concept. The first stage one-bit flip-flop 702 (as shown in FIG. 7B) may generate a scan output signal based on a scan input signal received at an input port of the first stage one-bit flip-flop, during a low phase of the clock signal CK. If the scan enable signal of the first stage one-bit flip-flop 702 is high, the first stage one-bit flip-flop 702 may receive a scan input data, during a low phase of the clock signal CK. The first stage one-bit flip-flop 702 can generate a scan output from the received scan input. When the scan enable signal is low, the first stage one-bit flip-flop 702 may receive normal input data without the scan functionality. The first stage one-bit flip-flop 702 can generate the output from the received input data. Upon receiving normal input data, the flip-flop may work as a normal D flip-flop without scan functionality.

In an embodiment, the first stage one-bit flip-flop 702 may also have a reset functionality. The first stage one-bit flip-flop 702 may receive an asynchronous reset signal as an input on the reset pin of the first stage one-bit flip-flop 702, that resets the final output Q0 of the first stage one-bit flip-flop 702 with scan functionality as zero.

In an embodiment, the second stage one-bit flip-flop 704 may generate a scan final output signal based on the scan output signal received from the first stage at the scan input port of the second stage one-bit flip-flop. The first stage one-bit flip-flop 702 and the second stage one-bit flip-flop 704 may function according to the explanation of the scan flip-flop given in FIG. 5C.

In an embodiment, the first stage flip-flop 702 includes a first master stage flip-flop, first slave stage flip-flop and a first transistor bridge circuit for sharing the clock signal CK between the first master stage flip-flop and the first slave stage of flip-flop. The first master stage flip-flop includes a first input and scan multiplexer; and a first master latch. The first master latch includes a first multistage cascaded controlled inverting circuit and a first master feedback circuit.

In an embodiment, the first input and scan multiplexer are configured to generate the inverted signal of at least one of an input data and a scan input based on a state of a scan enable signal received at an input ports of the flip-flop during a low phase of the clock signal CK and provide the output to the first master latch flip-flop.

In an embodiment, the first multistage cascaded controlled inverting circuit may generate a first scan buffered output from a received inverted data input and scan input from the first input and scan multiplexer, through a number of inverting stages comprising of at least one clock-controlled inverter coupled in series with a buffer.

In an embodiment, a first master internal feedback within the first master stage flip-flop is provided by the first scan buffered data output, the scan buffered inverted data and the clock signal CK when clock signal CK is high through a pull-down network.

In an embodiment, the first slave stage flip-flop includes a first cross-coupled inverter (which is coupled with a transistor bridge circuit in the pull-up network); a first output inverter; a first scan output inverter; and a first active pull-down circuit. The first cross-coupled inverter generates the first final output through the first output inverter from the received scan buffered output from the first master stage flip-flop, wherein the scan buffered output controls the output state of the cross-coupled inverter coupled with an active pull-down circuit when clock signal CK becomes high. The first scan output inverter is configured to generate the same output as the final output of the first stage one-bit flip-flop and provide the output (SInext0) of the first stage one-bit flip-flop as the scan input of the second stage one-bit flip-flop. The first slave feedback circuit provides the second internal feedback in the form of a previous slave stage output during a high phase of the clock signal CK, through the shared transistor bridge with common clock transistor when the clock signal CK is low.

In an embodiment, the second stage one-bit flip-flop comprises a second master stage flip-flop, a second slave stage flip-flop, and a second transistor bridge circuit for sharing a clock signal CK between the second master stage flip-flop and the second slave stage flip-flop. The second master stage flip-flop includes a second input and scan multiplexer, and a second master latch. The second master latch includes a second multistage cascaded controlled inverting circuit; and a second master feedback circuit.

In an embodiment, the second input and scan multiplexer are configured to provide an input of a scan enable pin and inverted scan enable along with data and scan input to the second master stage flip-flop, to generate a scan inverted output based on the state of scan output signal from first stage flip-flop and scan enable signal.

In an embodiment, the second multistage cascaded controlled inverting circuit generates the output of second master stage in the form of a second scan buffered output received from the received inverted data input and scan input from the second input and scan multiplexer.

In an embodiment, a second master stage internal feedback circuits within the second master flip-flop provides feedback by receiving the second scan buffered output, scan buffered inverted data along with the clock signal CK, when the clock signal CK is high through a pull-down network.

In an embodiment, the second slave flip-flop includes a second cross-coupled inverter (which is coupled with transistor bridge circuit in the pull-up network), a second output inverter, and a second active pull-down circuit. The second cross-coupled inverter may generate the scan final output signal through the second output inverter from the received second scan buffered output from the second master stage flip-flop. The second scan buffered output controls the output state of the second cross-coupled inverter coupled with second active pull-down circuit when clock signal CK becomes high. In an embodiment, the second slave feedback circuit provides the internal feedback in the second slave stage flip-flop when the clock signal CK is zero through the transistor bridge circuit.

In an embodiment, a flip-flop for a low power integrated circuit (IC) is designed in a standard cell library. Therefore, it is understood that the scope of the protection is extended to such a program and in addition to a computer readable storage device having codes therein, such computer readable storage device contains program codes for implementation of one or more operations of the method, when the program runs on a server or mobile device or any suitable programmable device. The method is implemented in at least one embodiment through or together with a software program written in e.g., Very high-speed integrated circuit Hardware Description Language (VHDL) or another programming language, or implemented by one or more VHDL or several software modules being executed on at least one hardware device. The hardware device can be any kind of portable device that can be programmed. The device may also include means which could be e.g., hardware like e.g., an ASIC, or a combination of hardware and software, e.g., an ASIC and an FPGA, or at least one microprocessor and at least one memory with software modules located therein. The method of embodiments could be implemented partly in hardware and partly in software. Alternatively, the inventive concept may be implemented on different hardware devices, e.g., using a plurality of CPUs.

Embodiments are set out in the following Clauses:
1. A flip-flop for a low power integrated circuit (IC), the flip-flop comprising:
   a master stage flip-flop;
   a slave stage flip-flop; and
   a transistor bridge circuit for sharing a clock signal between the master stage flip-flop and the slave stage flip-flop;
   wherein the master stage flip-flop is configured to generate a buffered data output on sensing a low phase of the clock signal from a received data input through a plurality of inverting stages comprising at least one controlled inverter coupled in series with a buffer, wherein a master stage internal feedback within the master stage flip-flop is provided by the buffered data output, the buffered inverted data and a high phase of the clock signal through a pull down network; and
   wherein the slave stage flip-flop is configured to generate a final output using the generated buffered data output from the master stage flip-flop, wherein the generated buffered data output controls the state of cross-coupled inverters connected to the transistor bridge circuit in the slave stage flip-flop, and wherein a slave stage internal feedback within the slave stage flip-flop is provided by the buffered data output and buffered inverted data along with the low phase of the clock signal using the transistor bridge circuit in a pull up network.
2. The flip-flop of Clause 1, wherein the master stage flip-flop comprises:
   an input data-controlled inverter; and
   a master latch comprising:
      a multistage cascaded controlled inverting circuit; and
      a master feedback circuit;
      wherein the input data-controlled inverter is configured to generate the inverted input data by receiving and inverting the input data in the low phase of the clock signal;
      wherein the multistage cascaded controlled inverting circuit is configured to generate the output of master stage in a form of buffered data output from the received inverted input data; and
      wherein the master feedback circuit becomes active at a high phase of the clock signal, and wherein the master feedback circuit is configured to provide the first internal feedback to the flip-flop.
3. The flip-flop of Clause 2, wherein the input data-controlled inverter comprises:
   a first pull-up transistor comprising a first p-channel metal-oxide-semiconductor (PMOS) transistor wherein a source terminal of the first PMOS transistor is connected to a drain terminal of a PMOS transistor of the transistor bridge circuit; and
   a first pull-down transistor comprising an first n-channel metal-oxide-semiconductor (NMOS) transistor, wherein a source terminal of the first NMOS transistor is grounded,
   wherein the drain terminal of the first pull-up and the first pull-down transistors provide the inverted input data as a first output of the input data-controlled inverter using the received input data as a first common input at a gate terminal of the first pull-up and the first pull-down transistors.
4. The flip-flop of Clause 2 or Clause 3, wherein the multistage cascaded controlled inverting circuit comprises a clock-controlled inverter cascaded in series with a buffer, wherein the clock-controlled inverter comprises: a second pull-up transistor comprising a second PMOS transistor; wherein the source terminal of the second PMOS transistor is connected a second drain terminal of a PMOS transistor of the transistor bridge circuit; and a second pull-down transistor comprising a second NMOS transistor; wherein the source terminal of the second NMOS transistor is grounded;
   wherein the drain terminal of the second PMOS transistor and the second NMOS transistor provide inverted data as the output of clock-controlled inverter; wherein a gate terminal of the second PMOS transistor and the second NMOS transistor are connected to the output of the input data-controlled inverter;
   wherein the multistage cascaded controlled inverting circuit provides an inverted output at the low phase of the clock.
5. The flip-flop of any preceding Clause, wherein:
   the transistor bridge circuit comprises a third PMOS transistor, a fourth PMOS transistor and a fifth PMOS transistor; and
   the fifth PMOS transistor is connected as a bridge between drain terminals of the third PMOS transistor and the fourth PMOS transistor, and is configured to receive a clock input at a gate terminal of the fifth PMOS transistor to trigger the fifth PMOS transistor.
6. The flip-flop of Clause 5, wherein:
   gate terminals of the third PMOS transistor and the fourth PMOS transistor receive inverting inputs generated from a last two inverters of multistage cascaded controlled inverting circuit; and
   at least one of the third PMOS transistor and the fourth PMOS transistor is in an active state irrespective of the clock signal.
7. The flip-flop of any of Clauses 2-4, or Clauses 5-6 when dependent on Clause 2, wherein:
   the master feedback comprises a first pull-down path comprising a third NMOS transistor connected in series with a fifth NMOS transistor and a second pull-down path comprising a fourth NMOS transistor connected in series with the fifth NMOS transistor; and
   the source terminal of the third NMOS transistor and the fourth NMOS transistor are connected in series with the fifth NMOS transistor.
8. The flip-flop of Clause 7, wherein: the source terminal of the third NMOS transistor and the fourth NMOS transistor is connected to the drain terminal of the fifth NMOS transistor, the source terminal of the fifth NMOS transistor is grounded; the drain terminal of the third NMOS transistor is connected to the output of the input data controlled inverter; and the drain terminal of the fourth NMOS transistor is connected to the output of the clock controlled inverter of the multistage cascaded inverting circuit.
9. The flip-flop of Clause 8, wherein:
   the gate terminal of the fifth NMOS transistor receive the clock signal, and the gate terminal of the third NMOS transistor and the fourth NMOS transistor receive inverting inputs generated from the multistage cascaded controlled inverting circuit, and
   at least one of the third NMOS transistor or the fourth NMOS transistor is ON irrespective of the phase of the clock signal.
10. The flip-flop of any preceding Clause, wherein the slave stage flip-flop comprises:
   the cross-coupled inverters, which is coupled to the transistor bridge circuit;
   an output inverter; and
   a slave feedback circuit;
   wherein the cross-coupled inverters is configured to generate the final output through the output inverter using the received buffered data output from the master stage flip-flop during the high phase of the clock signal; wherein the master stage flip-flop controls the output of the cross-coupled inverter based on the logic state of the buffered data output;
   wherein the slave feedback circuit provides second internal feedback, through the transistor bridge circuit at a low phase of the clock signal, and wherein the second internal feedback comprises a previous slave stage output during the high phase of the clock signal.
11. The flip-flop of Clause 10, wherein the cross-coupled inverters comprises two inverters connected back to back, driven at gate terminals by first and second pull-down paths; wherein the first pull down path comprises a sixth NMOS transistor connected in series with an eighth NMOS transistor and the second pull down path comprises a seventh NMOS transistor in series with the eighth NMOS transistor; and wherein a source terminal of each of the sixth NMOS transistor and the seventh NMOS transistor is connected in series with the eighth NMOS transistor.
12. The flip-flop of Clause 11, wherein the source terminal of each of the sixth NMOS transistor and the seventh NMOS transistor is connected to the drain terminal of the eighth NMOS transistor and the drain terminal of the sixth NMOS transistor is connected to the output of the first inverter of the cross-coupled inverters and the drain terminal of seventh NMOS transistor is connected to the output of the second inverter of the cross-coupled inverters; and the source terminal of the eighth NMOS transistor is grounded.
13. The flip-flop of Clause 11 or Clause 12, wherein the gate terminal of the eighth NMOS transistor is connected to the clock signal and the gate terminals of the sixth and the seventh NMOS transistor are connected to the inverting inputs generated from the last two inverting stages of multistage cascaded controlled inverting circuit; wherein at least one of the sixth NMOS transistor and the seventh NMOS transistor is in active state irrespective of the clock signal.
14. The flip-flop of any preceding Clause, wherein the buffered data output (X4) follows the input to the input data-controlled inverter, at low phase of the clock signal; and wherein the master feedback circuit of the master stage flip-flop becomes activated to hold the last buffer state at the low phase of the clock signal, when the clock signal is detected as high.
15. The flip-flop of any preceding Clause, wherein the slave stage flip-flop is configured to:
   conduct, on receiving a positive edge of the clock signal based on the master stage flip-flop output which controls the state of final output; wherein the cross-couple inverters coupled with transistor bridge circuit holds a previous final output when the clock signal is zero; and wherein the previous final output acts as the feedback.

The foregoing description of the specific embodiments will so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of embodiments and examples, those skilled in the art will recognize that the embodiments and examples disclosed herein can be practiced with modification within the scope of the embodiments as described herein.

## Claims

1. A flip-flop, the flip-flop comprising:
a master stage flip-flop (302);
a slave stage flip-flop (304); and
a transistor bridge circuit (306) for sharing a clock signal (CK) between the master stage flip-flop (302) and the slave stage flip-flop (304);
wherein the master stage flip-flop (302) is configured to generate a buffered data output (X4), on sensing a low phase of the clock signal (CK), from a received input data (D) through a plurality of inverting stages comprising at least one controlled inverter coupled in series with a buffer, wherein a master stage internal feedback within the master stage flip-flop (302) is provided by the buffered data output (X4), buffered inverted data (X3) and a high phase of the clock signal (CK) through a pull down network; and
wherein the slave stage flip-flop (304) is configured to generate a final output (Q) using the generated buffered data output (X4) from the master stage flip-flop (302), wherein the generated buffered data output (X4) controls the state of cross-coupled inverters (316) connected to the transistor bridge circuit (306) in the slave stage flip-flop (304), and wherein a slave stage internal feedback within the slave stage flip-flop (304) is provided by the buffered data output (X4) and the buffered inverted data (X3) along with the low phase of the clock signal (CK) using the transistor bridge circuit (306) in a pull up network.

2. The flip-flop of claim 1, wherein the master stage flip-flop (302) comprises:
an input data-controlled inverter (308); and
a master latch (310) comprising:
a multistage cascaded controlled inverting circuit (312); and
a master feedback circuit (314);
wherein the input data-controlled inverter (308) is configured to generate inverted input data (X1) by receiving and inverting the input data (D) in the low phase of the clock signal (CK);
wherein the multistage cascaded controlled inverting circuit (314) is configured to generate an output of master stage in a form of the buffered data output (X4) from the received inverted input data (X1); and
wherein the master feedback circuit (314) becomes active at a high phase of the clock signal (CK), and wherein the master feedback circuit (314) is configured to provide the master stage internal feedback to the flip-flop.

3. The flip-flop of claim 2, wherein the input data-controlled inverter (308) comprises:
a first pull-up transistor comprising a first p-channel metal-oxide-semiconductor, PMOS, transistor (P10) wherein a source terminal of the first PMOS transistor (P10) is connected to a drain terminal of a PMOS transistor (P1) of the transistor bridge circuit (306); and
a first pull-down transistor comprising a first n-channel metal-oxide-semiconductor, NMOS, transistor (N10), wherein a source terminal of the first NMOS (N10) transistor is grounded,
wherein the drain terminals of the first pull-up and the first pull-down transistors provide the inverted input data (X1) as a first output of the input data-controlled inverter (308) using the received input data (D) as a first common input at gate terminals of the first pull-up and the first pull-down transistors.

4. The flip-flop of claim 2 or claim 3, wherein the multistage cascaded controlled inverting circuit (312) comprises a clock-controlled inverter cascaded in series with a buffer,
wherein the clock-controlled inverter comprises:
a second pull-up transistor comprising a second PMOS transistor (P4), wherein the source terminal of the second PMOS transistor (P4) is connected a drain terminal of a further PMOS transistor (P2) of the transistor bridge circuit (306); and
a second pull-down transistor comprising a second NMOS transistor (N4), wherein the source terminal of the second NMOS transistor (N4) is grounded;
wherein the drain terminals of the second PMOS transistor (P4) and the second NMOS transistor (N4) provide inverted data (X2) as the output of clock-controlled inverter,
wherein gate terminals of the second PMOS transistor (P4) and the second NMOS transistor (N4) are connected to the output of the input data-controlled inverter (308), and
wherein the multistage cascaded controlled inverting circuit (312) provides an inverted output at the low phase of the clock.

5. The flip-flop of any preceding claim, wherein:
the transistor bridge circuit (306) comprises a third PMOS transistor (P1), a fourth PMOS transistor (P2) and a fifth PMOS transistor (P3); and
the fifth PMOS transistor (P5) is connected as a bridge between drain terminals of the third PMOS transistor (P1) and the fourth PMOS transistor (P2), and is configured to receive a clock input (CK) at a gate terminal of the fifth PMOS transistor (P3) to trigger the fifth PMOS transistor (P3).

6. The flip-flop of claim 5, wherein:
gate terminals of the third PMOS transistor (P1) and the fourth PMOS transistor (P2) are configured to receive inverting inputs generated from a last two inverters of a multistage cascaded controlled inverting circuit (312); and
the flip-flop is configured such that at least one of the third PMOS transistor (P1) and the fourth PMOS transistor (P2) is in an active state irrespective of the clock signal (CK).

7. The flip-flop of any of claims 2-4, or any of claims 5-6 when dependent on claim 2, wherein:
the master feedback circuit (314) comprises a first pull-down path comprising a third NMOS transistor (N1) connected in series with a fifth NMOS transistor (N3) and a second pull-down path comprising a fourth NMOS transistor (N2) connected in series with the fifth NMOS transistor (N3); and
the source terminals of the third NMOS transistor (N1) and the fourth NMOS transistor (N2) are connected in series with the fifth NMOS transistor (N3).

8. The flip-flop of claim 7, wherein:
the source terminals of the third NMOS transistor (N1) and the fourth NMOS transistor (N2) are connected to the drain terminal of the fifth NMOS transistor (N3);
the source terminal of the fifth NMOS transistor (N3) is grounded;
the drain terminal of the third NMOS transistor (N1) is connected to the output of the input data controlled inverter (308); and
the drain terminal of the fourth NMOS transistor (N2) is connected to the output of a clock controlled inverter of the multistage cascaded inverting circuit (312).

9. The flip-flop of claim 8, wherein:
the gate terminal of the fifth NMOS transistor (N3) is configured to receive the clock signal (CK), and the gate terminals of the third NMOS transistor (N1) and the fourth NMOS transistor (N2) are configured to receive inverting inputs generated from the multistage cascaded controlled inverting circuit (312), and
the flip-flop is configured such that at least one of the third NMOS transistor (N1) or the fourth NMOS transistor (N2) is ON irrespective of the phase of the clock signal.

10. The flip-flop of any preceding claim, wherein the slave stage flip-flop (304) comprises:
the cross-coupled inverters (316), which are coupled to the transistor bridge circuit (306);
an output inverter (318); and
a slave feedback circuit (322);
wherein the cross-coupled inverters (316) are configured to generate the final output (Q) through the output inverter (318) using the received buffered data output (X4) from the master stage flip-flop (302) during the high phase of the clock signal (CK),
wherein the master stage flip-flop (302) is configured to control the output of the cross-coupled inverters (316) based on the logic state of the buffered data output (X4);
wherein the slave feedback circuit (322) is configured to provide the slave stage internal feedback, through the transistor bridge circuit (306) at the low phase of the clock signal (CK), and wherein the second internal feedback comprises a previous slave stage output during the high phase of the clock signal (CK).

11. The flip-flop of claim 10, wherein the cross-coupled inverters (316) comprise two inverters (IN3, IN4) connected back to back, driven at gate terminals by first and second pull-down paths,
wherein the first pull down path comprises a sixth NMOS transistor (N14) connected in series with an eighth NMOS transistor (N16) and the second pull down path comprises a seventh NMOS transistor (N15) connected in series with the eighth NMOS transistor (N16), and
wherein a source terminal of each of the sixth NMOS transistor (N14) and the seventh NMOS transistor (N15) is connected in series with the eighth NMOS transistor (N16).

12. The flip-flop of claim 11, wherein the source terminal of each of the sixth NMOS transistor (N14) and the seventh NMOS transistor (N15) is connected to the drain terminal of the eighth NMOS transistor (N16) and the drain terminal of the sixth NMOS transistor (N14) is connected to the output of the first inverter (IN3) of the cross-coupled inverters (316) and the drain terminal of seventh NMOS transistor (N15) is connected to the output of the second inverter (IN4) of the cross-coupled inverters (316), and the source terminal of the eighth NMOS transistor (N16) is grounded.

13. The flip-flop of claim 11 or claim 12, wherein the gate terminal of the eighth NMOS transistor (N16) is connected to the clock signal (CK) and the gate terminals of the sixth and the seventh NMOS transistor (N14, N15) are connected to the inverting inputs generated from the last two inverting stages of multistage cascaded controlled inverting circuit (312), wherein the flip-flop is configured such that at least one of the sixth NMOS transistor (N14) and the seventh NMOS transistor (N15) is in active state irrespective of the clock signal.

14. The flip-flop of any preceding claim, wherein the buffered data output (X4) follows the input to the input data-controlled inverter (308), at low phase of the clock signal (CK); and wherein a master feedback circuit (314) of the master stage flip-flop (302) is configured to become activated to hold the last buffer state at the low phase of the clock signal (CK), when the clock signal (CK) is detected as high.

15. The flip-flop of any preceding claim, wherein the slave stage flip-flop (304) is configured to conduct, on receiving a positive edge of the clock signal (CK) based on the buffered data output (X4) which controls the state of final output,
wherein the cross-coupled inverters (316) coupled with the transistor bridge circuit (306) are configured to hold a previous final output when the clock signal (CK) is zero, and
wherein the previous final output acts as the slave stage internal feedback.
